# EUROPEAN PATENT APPLICATION

(11) **EP 4 776 328 A1**
(43) Date of publication of application: **15.07.2026**
(21) Application number: 24863049.3
(22) Date of filing: 09.08.2024

(54) **DISPLAY DEVICE AND MANUFACTURING METHOD THEREFOR**

(30) Priority: 05.09.2023 KR 20230117513
(71) Applicant: Samsung Display Co., Ltd., Yongin-si, Gyeonggi-do 17113 (KR)
(72) Inventor: KIM, Kyung Tae, Yongin-Si Gyeonggi-do 17113 (KR); KIM, Myeong Ho, Yongin-Si Gyeonggi-do 17113 (KR); KIM, Myoung Hwa, Yongin-Si Gyeonggi-do 17113 (KR); MOON, Yeon Keon, Yongin-Si Gyeonggi-do 17113 (KR)
(74) Representative: Marks & Clerk LLP
(86) International application number: PCT/KR2024/011880
(87) International publication number: WO 2025/053467

(57) **Abstract**

This display device comprises: a substrate; a first transistor including a first bottom gate electrode disposed on the substrate, a first active layer disposed on the first bottom gate electrode and including a first channel region, a first drain region, and a first source region, and a first top gate electrode disposed on a portion of the first active layer in which the first channel region is included; a first insulating layer disposed between the first bottom gate electrode and the first active layer; and a second insulating layer disposed between the first active layer and the first top gate electrode. The second insulating layer includes a first portion having a first thickness and disposed on the portion of the first active layer in which the first channel region is included, and a second portion having a second thickness smaller than the first thickness and disposed on the remainder of the first active layer.

## Description

### [Technical Field]

Embodiments of the present disclosure relate to a display device and a method for manufacturing the same.

### [Background Art]

The importance of display devices has gradually increased with the development of multimedia. Accordingly, various display devices such as liquid crystal display devices and light emitting display devices have been developed.

### [Detailed Description of the Invention]

### [Technical Problem]

The problem to be solved by the present disclosure is to provide a display device capable of improving operation characteristics of a transistor, and a method for manufacturing the same.

The tasks of the present invention are not limited to the tasks mentioned above, and other technical tasks not mentioned will be clearly understood by those skilled in the art from the description below.

### [Technical Solution]

A display device according to an embodiment includes a substrate, a first transistor including a first bottom gate electrode disposed on the substrate, a first active layer disposed on the first bottom gate electrode and including a first channel region, a first drain region, and a first source region, and a first top gate electrode disposed on a portion of the first active layer including the first channel region, a first insulating layer disposed between the first bottom gate electrode and the first active layer, and a second insulating layer disposed between the first active layer and the first top gate electrode. The second insulating layer may include: a first portion disposed on a portion of the first active layer including the first channel region and having a first thickness, and a second portion disposed on a remaining portion of the first active layer and having a second thickness smaller than the first thickness.

In an embodiment, the first channel region may include: a lower layer portion adjacent to the first bottom gate electrode and having a first length, and an upper layer portion adjacent to the first top gate electrode and having a second length greater than the first length.

In an embodiment, in a cross-section of the first active layer, the first channel region may have an inverted trapezoidal shape of which a length increases from the lower layer portion toward the upper layer portion.

In an embodiment, the first channel region may include a lower layer portion adjacent to the first bottom gate electrode and an upper layer portion adjacent to the first top gate electrode, and the lower layer portion of the first channel region may have a higher carrier concentration than the upper layer portion of the first channel region.

In an embodiment, the second insulating layer may include an upper layer portion in contact with the first top gate electrode, and the upper layer portion of the second insulating layer and the first top gate electrode may have a same pattern shape.

In an embodiment, the second insulating layer may include an upper layer portion in contact with the first top gate electrode, and the upper layer portion of the second insulating layer and the first top gate electrode may have a same area.

In an embodiment, a side surface of the first top gate electrode and a side surface of the second insulating layer may have an inclined surface having a continuously connected form.

In an embodiment, the second insulating layer may have a step having a stair shape at a boundary between the first portion and the second portion.

In an embodiment, the display device may further include a third insulating layer covering the second insulating layer and the first top gate electrode.

In an embodiment, the display device may further include at least one of a first drain electrode disposed on the third insulating layer and connected to the first drain region through a first contact hole penetrating through the second insulating layer and the third insulating layer, and a first source electrode disposed on the third insulating layer and connected to the first source region through a second contact hole penetrating through the second insulating layer and the third insulating layer. The second insulating layer may entirely cover the first active layer except for a portion where at least one of the first contact hole and the second contact hole is formed.

In an embodiment, the first bottom gate electrode may be electrically connected to the first top gate electrode.

In an embodiment, the display device may further include a pixel including the first transistor.

In an embodiment, the pixel may further include a second transistor, and the second transistor may include a second bottom gate electrode disposed on the substrate, a second active layer disposed on the first insulating layer and including a second channel region, a second drain region, and a second source region, and a second top gate electrode disposed on the second insulating layer and disposed on a portion of the second active layer including the second channel region.

In an embodiment, the second insulating layer may cover the second active layer and have the first thickness and the second thickness at a portion of the second active layer including the second channel region and a remaining portion of the second active layer, respectively.

In an embodiment, the first active layer and the second active layer may include the same oxide semiconductor.

In an embodiment, the display device may further include a driver connected to the pixel and a driver transistor included in the driver, and the driver transistor may include a third bottom gate electrode disposed on the substrate, a third active layer disposed on the first insulating layer and including a third channel region, a third drain region, and a third source region, and a third top gate electrode disposed on the second insulating layer and disposed on a portion of the third active layer including the third channel region.

In an embodiment, the second insulating layer may cover the third active layer and have the first thickness and the second thickness at a portion of the third active layer including the third channel region and a remaining portion of the third active layer, respectively.

In an embodiment, the first active layer and the third active layer may include the same oxide semiconductor.

A method for manufacturing a display device according to an embodiment includes forming a first insulating layer on a substrate, forming an active layer on the first insulating layer, forming a second insulating layer on the substrate, the second insulating layer covering the active layer, forming a conductive film on the second insulating layer, forming a top gate electrode overlapping a portion of the active layer by etching the conductive film, and forming a third insulating layer on the second insulating layer and the top gate electrode. The method for manufacturing a display device further includes, before the forming of the third insulating layer, etching a portion of the second insulating layer that does not overlap the top gate electrode by a partial thickness using the same mask as a mask used to etch the conductive film or using the top gate electrode as a mask.

In an embodiment, the method for manufacturing a display device may further include, before the forming of the first insulating layer, forming a bottom gate electrode on the substrate, and the active layer may be formed on the first insulating layer so as to overlap at least a portion of the bottom gate electrode.

Other details of the embodiments are included in the detailed description and the drawings.

### [Effects of the Invention]

A display device according to embodiments includes a transistor including a bottom gate electrode, an active layer, and a top gate electrode, and an insulating layer disposed between the active layer and the top gate electrode of the transistor. The insulating layer may have a first thickness on a portion of the active layer including a channel region and have a second thickness smaller than the first thickness on the remaining portion of the active layer.

With the display device and a method for manufacturing the same according to embodiments, in a manufacturing process of the display device including the transistor, it is possible to expand or ensure an effective channel length of the transistor by reducing an amount of hydrogen introduced or permeated into the active layer while appropriately and/or easily making a source region and a drain region of the active layer conductive. Accordingly, threshold voltage roll-off (Vth roll-off) of the transistor may be prevented, and operation characteristics of the transistor may be improved and/or stabilized. For example, even though a size (e.g., a channel length) of the transistor is reduced in a high-resolution display device or the like, the effective channel length of the transistor may be appropriately and/or easily ensured to improve the operation characteristics of the transistor.

The effects according to the embodiments are not limited to the contents exampled above, and more diverse effects are included in the present disclosure.

### [Brief Description of the Drawings]

FIG. 1 is a plan view illustrating a display device according to an embodiment;
FIG. 2 is a plan view illustrating a display panel of FIG. 1;
FIG. 3 is an equivalent circuit diagram illustrating a pixel according to an embodiment;
FIG. 4 is an equivalent circuit diagram illustrating a pixel according to an embodiment;
FIG. 5 is a cross-sectional view illustrating the display panel according to an embodiment;
FIG. 6 is a cross-sectional view illustrating the display panel according to an embodiment;
FIG. 7 is a cross-sectional view illustrating the display panel according to an embodiment;
FIGS. 8a and 8b are graphs illustrating an effective channel length of a channel region formed in a transistor according to an etching degree of a gate insulating layer;
FIGS. 9a and 9b are graphs illustrating a change in characteristics of a transistor according to an etching degree of a gate insulating layer; and
FIGS. 10 to 16 are cross-sectional views illustrating a method for manufacturing the display device according to an embodiment.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

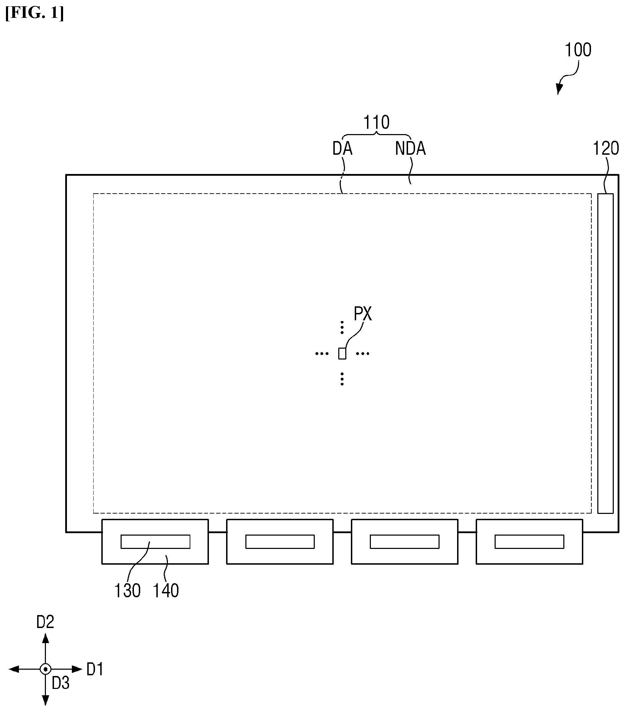

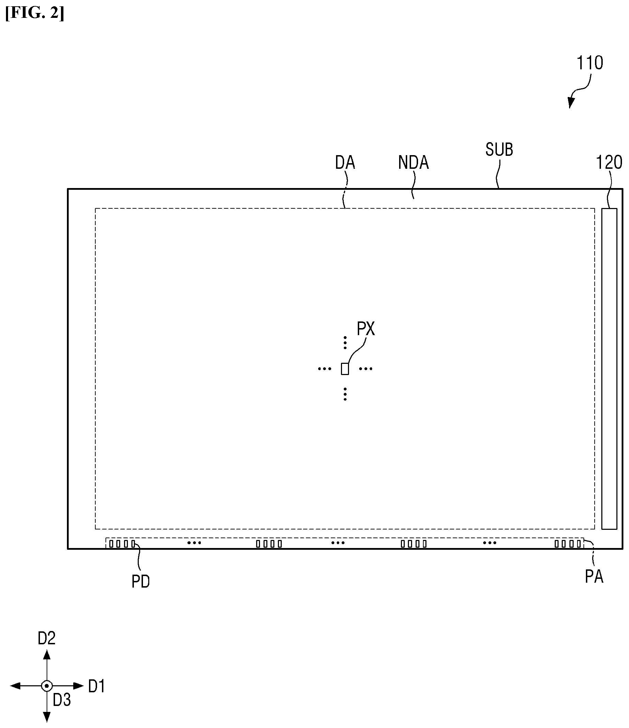

FIG. 1 is a plan view illustrating a display device 100 according to an embodiment. FIG. 2 is a plan view illustrating a display panel 110 of FIG. 1.

Referring to FIGS. 1 and 2, the display device 100 is a device that displays a moving image or a still image, and may be used as a display screen of various products such as televisions, laptop computers, monitors, billboards, and the Internet of Things (IOT) as well as portable electronic devices such as mobile phones, smartphones, tablet personal computers (PCs), smart watches, watch phones, mobile communication terminals, electronic notebooks, electronic books, portable multimedia players (PMPs), navigation devices, and ultra mobile PCs (UMPCs). Such electronic devices are only examples, and the display device 100 may also be adopted in other electronic devices.

In an embodiment, the display device 100 may be a light emitting display device such as an organic light emitting display device including organic light emitting diodes, a quantum dot light emitting display device including quantum dot light emitting layers, an inorganic light emitting display device including inorganic semiconductors, or a micro light emitting display device using micro light emitting diodes such as micro or nano light emitting diodes (micro LEDs or nano LEDs), but is not limited thereto. For example, the display device 100 may also be a type of display device other than the light emitting display device. Hereinafter, embodiments in which the display device 100 is an organic light emitting display device have been disclosed.

The display device 100 may include a display panel 110 including pixels PX, and a first driver 120 and second drivers 130 supplying driving signals to the pixels PX. The display device 100 may further include additional components. For example, the display device 100 may further include a power supply unit for supplying source voltages to the pixels PX, the first driver 120, and the second drivers 130, a timing controller for controlling operations of the first driver 120 and the second drivers 130, and the like.

The display panel 110 may include a display area DA and a non-display area NDA (also referred to as a "bezel area"). The display area DA may be an area displaying an image by including the pixels PX. The non-display area NDA is an area other than the display area DA, and an image may not be displayed in the non-display area NDA. In an embodiment, the non-display area NDA may be positioned around the display area DA, and may surround the display area DA.

In FIGS. 1 and 2, a first direction D1, a second direction D2, and a third direction D3 are defined. In an embodiment, the first direction D1 and the second direction D2 may be perpendicular to each other, the first direction D1 and the third direction D3 may be perpendicular to each other, and the second direction D2 and the third direction D3 may be perpendicular to each other. For example, the first direction D1 may be a transverse direction (e.g., a row direction or an X-axis direction) of the display panel 110, and the second direction D2 may be a longitudinal direction (e.g., a column direction or a Y-axis direction) of the display panel 110. The third direction D3 may be a thickness direction (e.g., a height direction or a Z-axis direction) of the display panel 110.

In an embodiment, the display panel 110 may have a rectangular shape in plan view. For example, the display panel 110 may include two first sides extending in the first direction D1 and two second sides extending in the second direction D2 crossing the first direction D1. It has been illustrated in FIGS. 1 and 2 that the display panel 110 has a shape in which the first side in the transverse direction is longer than the second side in the longitudinal direction, but a shape of the display panel 110 is not limited thereto. For example, the display panel 110 may also have a shape in which the second side in the longitudinal direction is longer than the first side in the transverse direction or have a shape in which lengths of the first side and the second side are substantially the same as each other.

In an embodiment, the display panel 110 may include an angled corner at a portion where the first side and the second side meet, but is not limited thereto. For example, the display panel 110 may also include a rounded corner at a portion where the first side and the second side meet.

The shape of the display panel 110 in plan view is not limited to the illustrated rectangular shape, and may also be other shapes. For example, the display panel 110 may have a square shape, a non-rectangular polygonal shape, a circular shape, an elliptical shape, an irregular shape, or other shapes in plan view.

In an embodiment, the display panel 110 may be substantially flat on a plane defined by the first direction D1 and the second direction D2, and may have a uniform thickness in the third direction D3. In another embodiment, the display panel 110 may be provided in a three-dimensional shape having a curved surface or the like.

The display panel 110 may be provided as a panel having rigid characteristics so as not to be substantially deformed or be provided as a panel having flexible characteristics so as to be deformed, for example, folded, bent, or rolled, in at least a portion thereof. The display panel 110 may be provided to the display device 100 in a state in which it is not bent or provided to the display device 100 in a state in which it is bent in some sections.

The display panel 110 may include a substrate SUB and pixels PX disposed on the substrate SUB. The pixels PX may be disposed in a display area DA on the substrate SUB.

The substrate SUB is a base member for manufacturing or providing the display panel 110, and may constitute a base surface of the display panel 110. The substrate SUB may include a display area DA and a non-display area NDA positioned around the display area DA.

The display area DA may have various shapes according to embodiments. For example, the display area DA may a rectangular shape, a non-rectangular polygonal shape, a circular shape, an elliptical shape, an irregular shape, or other shapes. In an embodiment, the display area DA may have a shape matching (or corresponding) the shape of the display panel 110, but is not limited thereto.

The display area DA may include pixel areas in which the pixels PX are provided and/or disposed. For example, each pixel PX may be disposed in each pixel area positioned in the display area DA. In an embodiment, the display device 100 may be a light emitting display device, and each pixel PX may include a light emitting element positioned in each emission area and a pixel circuit connected to the light emitting element. In describing embodiments, the term "connection" may include the meaning of an electrical connection and/or a physical connection.

Each pixel area may include an emission area in which a light emitting element of a corresponding pixel is positioned and the pixel emits light and a pixel circuit area in which circuit elements constituting a pixel circuit of the corresponding pixel are positioned. In an embodiment, the emission area and the pixel circuit area of each pixel PX may overlap each other, but are not limited thereto.

The pixels PX may be arranged in the display area DA. For example, the pixels PX may be arranged in the display area DA in a stripe structure, a delta structure, a PenTile^{™} structure, or other arrangement structures.

The non-display area NDA may include a driving circuit area positioned on at least one side of the display area DA and a pad area PA in which pads PD are disposed. At least one driver, the pads PD, lines, and the like, may be disposed in the non-display area NDA.

At least one driver for driving the pixels PX or a portion of the driver may be disposed in the driving circuit area. As an example, circuit elements constituting the first driver 120 may be disposed in the driving circuit area on the substrate SUB. In an embodiment, the circuit elements of the first driver 120 may be formed in the display panel 110 together with the pixels PX.

The pads PD may be disposed in the pad area PA. At least one circuit board 140 may be disposed on and/or bonded onto the pad area PA. In an embodiment, a plurality of circuit boards 140 connected to different pads PD may be disposed on the pad area PA. The pads PD may include signal pads and power pads for transferring driving signals and source voltages required for driving the pixels PX and/or the first driver 120 to the inside of the display panel 110.

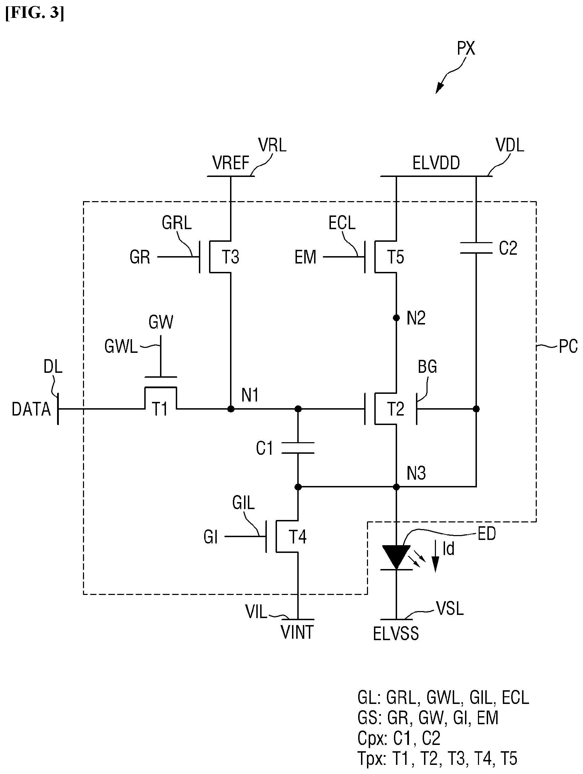

The first driver 120 and the second driver 130 may generate driving signals for controlling operation timings, luminance, and the like, of the pixels PX, and may supply the driving signals to the pixels PX. For example, the first driver 120 may be a gate driver including a scan driver, and may be connected to the pixels PX through respective gate lines. The first driver 120 may supply respective gate signals (e.g., driving signals controlling the operation timing and the like of the pixels PX, including a first gate signal GW of FIG. 3) to the pixels PX. The second driver 130 may be a data driver including source driving circuits, and may be connected to the pixels PX through respective data lines. The second driver 130 may supply respective data signals to the pixels PX.

In an embodiment, at least one of the first driver 120 and the second driver 130 or a portion of the at least one driver may be embedded in the display panel 110. For example, the first driver 120 or a portion of the first driver 120 may be disposed on the substrate SUB of the display panel 110 and be disposed and/or formed in the non-display area NDA.

It has been illustrated in FIG. 1 that the first driver 120 is formed in the non-display area NDA on one side of the display area DA (e.g., the right side of the display area DA), but embodiments are not limited thereto. For example, the first driver 120 may also be positioned only in the non-display area NDA on the other side of the display area DA (e.g., the left side of the display area DA), or be positioned in the non-display areas NDA on both sides of the display area DA (e.g., the left side and the right side of the display area DA). Alternatively, a portion of the first driver 120 (e.g., some of the circuit elements constituting the first driver 120) may be positioned in the non-display area NDA, and the other portion of the first driver 120 (e.g., the others of the circuit elements constituting the first driver 120) may be positioned in a non-emission area (e.g., an area between emission areas of the pixels PX) inside the display area DA.

In an embodiment, the other of the first driver 120 and the second driver 130 or a portion of the other driver may be disposed or formed outside the display panel 110 and electrically connected to the display panel 110. For example, the second driver 130 or a portion of the second driver 130 may be implemented as a plurality of integrated circuit chips and may be disposed on the circuit board 140 electrically connected to the pixels PX of the display panel 110. In an embodiment, the second driver 130 may be integrated as an integrated circuit chip separate from the timing controller or be integrated as each integrated circuit chip together with the timing controller. The second driver 130 may be implemented as at least one integrated circuit chip and mounted on the non-display area NDA of the display panel 110.

The circuit board 140 may be connected to the display panel 110 through the pads PD. In an embodiment, the circuit board 140 may be a flexible printed circuit board (FPCB), a printed circuit board (PCB), or a flexible film such as a chip on film (COF), but is not limited thereto. In an embodiment, the circuit board 140 may be connected to the timing controller, the power supply unit, and the like, through another circuit board, a connector, or the like.

FIG. 3 is an equivalent circuit diagram illustrating a pixel PX according to an embodiment. The pixel PX in FIG. 3 is only an example, and a structure or a type of the pixel PX may be changed according to embodiments.

Referring to FIG. 3 in addition to FIGS. 1 and 2, the pixel PX may include a light emitting element ED and a pixel circuit PC connected to the light emitting element ED. The light emitting element ED is a light source of the pixel PX and may be, for example, an organic light emitting diode, but is not limited thereto. The pixel circuit PC may control an emission timing and luminance of the light emitting element ED.

The pixel circuit PC may include pixel transistors Tpx and at least one pixel capacitor Cpx. For example, the pixel circuit PC may include first to fifth transistors T1 to T5, and first and second capacitors C1 and C2. A structure of the pixel circuit PC or types of circuit elements constituting the pixel circuit PC may be changed according to embodiments. An embodiment in which the pixel transistors Tpx are all N-type transistors has been illustrated in FIG. 3, but types of the pixel transistors Tpx are not limited thereto. For example, at least one pixel transistor Tpx may also be formed as a P-type transistor.

The pixel circuit PC may supply a driving current Id to the light emitting element ED in response to the driving signals supplied from the first driver 120 and the second driver 130. For example, the pixel circuit PC may supply the driving current Id to the light emitting element ED in response to respective gate signals GS supplied from the first driver 120 through respective gate lines GL and a data signal DATA supplied from the second driver GS through a data line DL.

The second transistor T2 may be a driving transistor of the pixel PX of which a magnitude of a drain-source current (e.g., the driving current Id) is determined according to its gate-source voltage. The first, third, fourth, and fifth transistors T1, T3, T4, and T5 may be switching transistors turned on or turned off according to their respective gate-source voltages (substantially, their respective gate voltages). Depending on a type (e.g., a P-type or N-type transistor) and/or an operation condition of each of the first to fifth transistors T1 to T5, a first electrode of each of the first to fifth transistors T1 to T5 may be a drain electrode (or a drain region) or a source electrode (or a source region), and a second electrode of each of the first to fifth transistors T1 to T5 may be an electrode different from the first electrode. For example, when the first electrode is the drain electrode, the second electrode may be the source electrode.

The pixel PX may be connected to a first gate line GWL transferring a first gate signal GW (e.g., a scan signal), a second gate line GIL transferring a second gate signal GI, a third gate line GRL transferring a third gate signal GR, an emission control line ECL transferring an emission control signal EM, and the data line DL transferring the data signal DATA. In addition, the pixel PX may be connected to a first pixel power line VDL transferring a first pixel voltage ELVDD (also referred to as a "first pixel source voltage") and a second pixel power line VSL transferring a second pixel voltage ELVSS (also referred to as a "second pixel source voltage"). In an embodiment, the pixel PX may be further connected to an initialization power line VIL transferring an initialization voltage VINT (also referred to as a "third pixel source voltage") and a reference power line VRL transferring a reference voltage VREF (also referred to as a "fourth pixel source voltage").

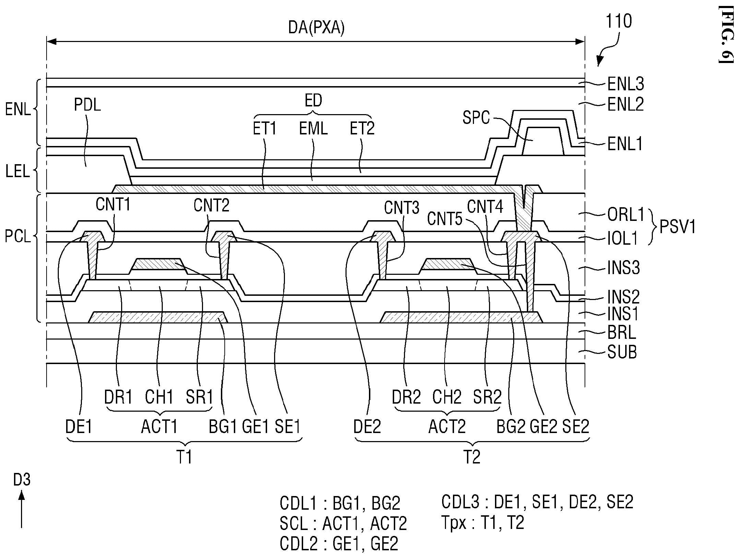

In an embodiment, the first to fifth transistors T1 to T5 may be positioned in each pixel area (e.g., a pixel area PXA of any one pixel PX provided in a display area DA of FIG. 6), and may be oxide transistors (also referred to as "oxide semiconductor transistors") including an oxide semiconductor (e.g., an oxide semiconductor material). For example, an active layer (also referred to as an "active pattern" or a "semiconductor pattern") of each of the first to fifth transistors T1 to T5 may be made of an oxide semiconductor. However, embodiments are not limited thereto. For example, at least one pixel transistor Tpx may also be made of a semiconductor material (e.g., amorphous silicon or polysilicon) other than the oxide semiconductor.

The oxide semiconductor has high carrier mobility (e.g., high electron mobility in a case of an N-type transistor) and a low leakage current, and accordingly, a great voltage drop may not occur even though a driving time of the oxide transistor becomes long. For example, even when the pixel PX including the oxide transistor is driven at a low frequency, a change in luminance and/or color of an image due to a voltage drop is not large, and thus, the pixel PX may be driven at the low frequency. In a case of the display device 100 in which the first to fifth pixel transistors T1 to T5 include the oxide semiconductor, a leakage current of the pixel PX may be reduced or prevented and power consumption may be reduced.

The oxide semiconductor is sensitive to light, such that a current amount or the like may be changed due to external light. In an embodiment, a light blocking pattern, a lower electrode (e.g., a bottom gate electrode, or the like, may be disposed below the active layer constituting at least one pixel transistor Tpx (e.g., at least one of the first to fifth pixel transistors T1 to T5). Accordingly, a change in current amount of the pixel transistor Tpx due to the light may be prevented or reduced, and operation characteristics of the pixel transistor Tpx may be stabilized.

The first transistor T1 (also referred to as a "first pixel transistor") may include a gate electrode connected to the first gate line GWL, a first electrode connected to the data line DL, and a second electrode connected to a first node N1. The first transistor T1 may be turned on by the first gate signal GW (e.g., the first gate signal GW of a gate-on voltage) transferred through the first gate line GWL to connect the data line DL and the first node N1 to each other. Accordingly, the data signal DATA transferred through the data line DL may be transferred to the first node N1.

The second transistor T2 (also referred to as a "second pixel transistor") may include a gate electrode connected to the first node N1 (or a gate node), a first electrode (e.g., a drain electrode or a drain region) connected to a second node N2, and a second electrode (e.g., a source electrode or a source region) connected to a third node N3. The first electrode of the second transistor T2 may be connected to the first pixel power line VDL via the fifth transistor T5, and the second electrode of the second transistor T2 may be connected to the light emitting element ED. The second transistor T2 may function as the driving transistor of the pixel PX, and may control a magnitude (e.g., a current amount) of the driving current Id flowing to the light emitting element ED in response to the data signal DATA transferred according to a switching operation of the first transistor T1.

In an embodiment, the second transistor T2 may further include a bottom gate electrode BG (also referred to as a "back-gate electrode of the second transistor T2" or a "second bottom gate electrode") connected to the third node N3. When the second transistor T2 is formed as a transistor having a double gate structure (e.g., a double gate transistor having a source-sync. structure) by connecting the bottom gate electrode BG of the second transistor T2 to the third node N3 to which the second electrode (e.g., the source electrode) of the second transistor T2 is connected, operation characteristics of the second transistor T2 may be improved.

The third transistor T3 (also referred to as a "third pixel transistor") may include a gate electrode connected to the third gate line GRL, a first electrode connected to the reference power line VRL, and a second electrode connected to the first node N1. The third transistor T3 may be turned on by the third gate signal GR transferred through the third gate line GRL to transfer the reference voltage VREF transferred through the reference power line VRL to the first node N1.

The fourth transistor T4 (also referred to as a "fourth pixel transistor") may include a gate electrode connected to the second gate line GIL, a first electrode connected to the third node N3, and a second electrode connected to the initialization power line VIL. The fourth transistor T4 may be turned on by the second gate signal GI transferred through the second gate line GIL to transfer the initialization voltage VINT transferred through the initialization power line VIL to the third node N3.

The fifth transistor T5 (also referred to as a "fifth pixel transistor") may include a gate electrode connected to the emission control line ECL, a first electrode connected to the first pixel power line VDL, and a second electrode connected to the second node (or the first electrode of the second transistor T2). The fifth transistor T5 may be turned on by the emission control signal EM (e.g., the emission control signal EM of a gate-on voltage) transferred through the emission control line ECL to control an emission timing of the pixel PX.

The first capacitor C1 may be connected between the first node N1 and the third node N3. For example, the first capacitor C1 may be connected between the gate electrode and the second electrode of the second transistor T2. The first capacitor C1 is a storage capacitor of the pixel PX, and may store a voltage corresponding to a threshold voltage of the second transistor T2 and the data signal DATA (e.g., a data voltage).

The second capacitor C2 may be connected between the first pixel power line VDL and the third node N3. In an embodiment, capacitance of the second capacitor C2 may be smaller than capacitance of the first capacitor C1.

The light emitting element ED may be connected between the third node N3 and the second pixel power line VSL. For example, the light emitting element ED may include a first electrode (e.g., an anode electrode or a pixel electrode) connected to the third node N3, a second electrode (e.g., a cathode electrode or a counter electrode) opposing the first electrode and connected to the second pixel power line VSL, and a light emitting layer interposed between the first electrode and the second electrode. In an embodiment, the first electrode of the light emitting element ED may be an individual electrode provided individually to each pixel PX, and the second electrode of the light emitting element ED may be a common electrode shared by a plurality of pixels PX. The light emitting element ED may emit light with luminance corresponding to the driving current Id during a period in which the driving current Id is supplied from the pixel circuit PC.

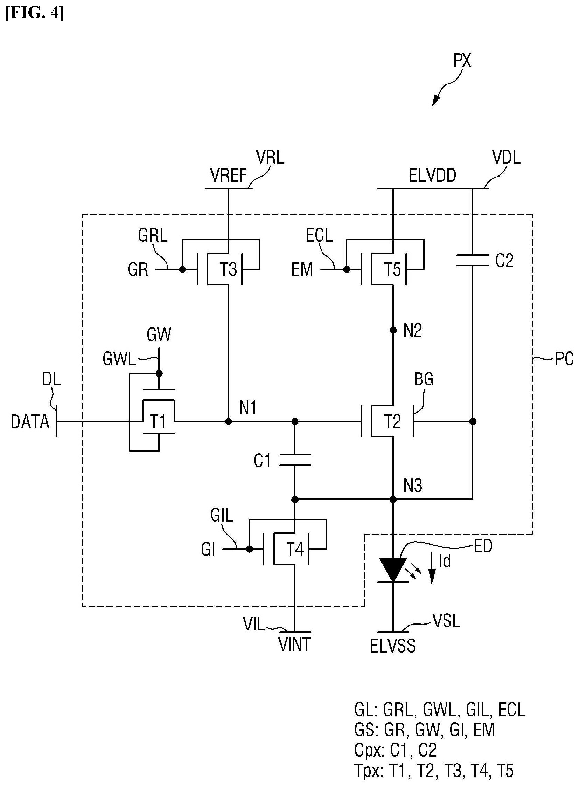

FIG. 4 is an equivalent circuit diagram illustrating a pixel PX according to an embodiment. For example, FIG. 4 illustrates an additional embodiment related to the switching transistors of the pixel transistors Tpx of FIG. 3.

Referring to FIG. 4 in addition to FIGS. 1 to 3, at least one of the switching transistors provided to the pixel PX may include a bottom gate electrode BG (e.g., a back-gate electrode) facing a gate electrode (e.g., a top gate electrode) with an active layer interposed therebetween. For example, at least one of the first, third, fourth, and fifth transistors T1, T3, T4, and T5 may include the bottom gate electrode BG.

An embodiment in which bottom gate electrodes BG are provided to all pixel transistors Tpx, respectively, will be disclosed in FIG. 4, and a reference numeral will be used for the bottom gate electrode BG provided to one pixel transistor Tpx (e.g., the second transistor T2). However, embodiments are not limited thereto. For example, at least one pixel transistor Tpx may not include the bottom gate electrode BG and/or may not be formed in a gate-sync. structure, a source-sync. structure, or the like.

In an embodiment, the first, third, fourth, and fifth transistors T1, T3, T4, and T5 may include the bottom gate electrodes BG, respectively. In an embodiment, the bottom gate electrode BG of each of the first, third, fourth, and fifth transistors T1, T3, T4, and T5 may be connected to a gate electrode of the corresponding pixel transistor Tpx. For example, each of the first, third, fourth, and fifth transistors T1, T3, T4, and T5 may be formed as a double gate transistor having a gate-sync. structure.

By providing the respective bottom gate electrodes BG to the first, third, fourth, and fifth transistors T1, T3, T4, and T5, it is possible to prevent or reduce changes in current amount of the first, third, fourth, and fifth transistors T1, T3, T4, and T5 due to light. In addition, when the bottom gate electrode BG of each of the first, third, fourth, and fifth transistors T1, T3, T4, and T5 is connected to a gate electrode (also referred to as a "top gate electrode") of the first, third, fourth, and fifth transistors T1, T3, T4, and T5, operation characteristics (e.g., switching characteristics) of the first, third, fourth, and fifth transistors T1, T3, T4, and T5 may be improved and/or stabilized. For example, by forming at least one switching transistor in the double gate structure such as the gate-sync. structure, it is possible to improve turn-off characteristics and a switching speed of the switching transistor, ensure an additional voltage tolerance, lower a leakage current, and improve voltage stability. As an example, by forming a small-sized switching transistor formed as an oxide transistor with a short channel length in the double gate structure such as the gate-sync. structure, it is possible to improve operation characteristics of the switching transistor.

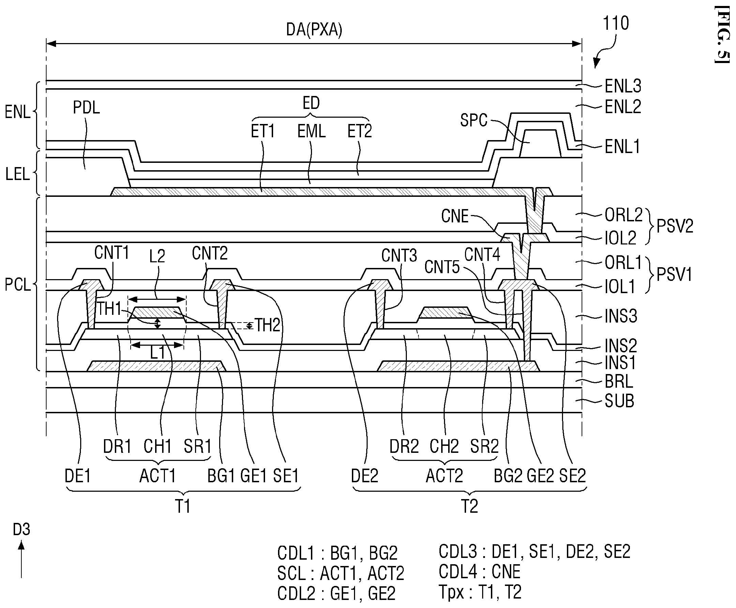

FIG. 5 is a cross-sectional view illustrating the display panel 110 according to an embodiment. FIG. 6 is a cross-sectional view illustrating the display panel 110 according to an embodiment. FIG. 5 illustrates a portion of the display area DA of the display panel 110 that includes a connection electrode CNE and a second passivation layer PSV2, and FIG. 6 illustrates a portion of the display area DA of the display panel 110 that does not include the connection electrode CNE and the second passivation layer PSV2.

FIGS. 5 and 6 illustrate a first transistor T1 and a second transistor T2 disposed in any one pixel area PXA as an example of circuit elements that may be provided or disposed in a panel circuit layer PCL of the display panel 110. In addition, FIGS. 5 and 6 illustrate a light emitting display panel including a light emitting element ED (e.g., an organic light emitting diode) as an example of the display panel 110 to which the embodiments may be applied. However, a type and/or a structure of the display panel 110 according to embodiments are not limited thereto. For example, the display panel 110 may include a light emitting element of another type and/or structure or may be a display panel of another type and/or structure other than the light emitting display panel.

Referring to FIGS. 5 and 6 in addition to FIGS. 1 to 4, the display panel 110 may include a substrate SUB (also referred to as a "base member" or a "base layer"), the panel circuit layer PCL, a light emitting element layer LEL, and an encapsulation layer ENL. The panel circuit layer PCL, the light emitting element layer LEL, and the encapsulation layer ENL may be disposed or provided to overlap each other on the substrate SUB. As an example, based on the display area DA, the panel circuit layer PCL, the light emitting element layer LEL, and the encapsulation layer ENL may be sequentially disposed or formed on the substrate SUB along the third direction D3. However, embodiments are not limited thereto, and mutual positions of the panel circuit layer PCL, light emitting element layer LEL, and encapsulation layer ENL may be changed. As an example, the panel circuit layer PCL and the light emitting element layer LEL may be integrated with each other or the light emitting element layer LEL may be disposed above the panel circuit layer PCL.

In an embodiment, the display panel 110 may further include additional components provided above and/or below the encapsulation layer ENL. For example, the display panel 110 may further include at least one of a sensor layer (e.g., a touch sensor layer), an optical layer (e.g., a color filter layer and/or a wavelength conversion layer), and a protective layer (e.g., a protective film, an insulating layer, an upper substrate, and/or a window). Each of the sensor layer, the optical layer, and/or the protective layer may be provided above the encapsulation layer ENL or be provided between the light emitting element layer LEL and the encapsulation layer ENL. In an embodiment, the sensor layer, the optical layer, and/or the protective layer may be provided in the display panel 110. For example, the sensor layer, the optical layer, and/or the protective layer may be manufactured integrally with the display panel 110. In another embodiment, the sensor layer, the optical layer, and/or the protective layer may be manufactured separately from the display panel 110 and attached to the display panel 110 through an adhesive layer or the like.

The substrate SUB is a base member for forming the display panel 110, and may be a substrate (or a film) having rigid characteristics or flexible characteristics. In an embodiment, the substrate SUB may be a substrate including an insulating material such as glass and having rigid characteristics, and may not be bent. In another embodiment, the substrate SUB may be a flexible substrate including polyimide or other insulating materials and capable of being deformed, for example, bent, folded, or rolled, and may or may not be bent. A type and/or a material of the substrate SUB may be changed according to embodiments.

The substrate SUB may include at least a display area DA. In an embodiment, the display area DA may include pixel areas PXA corresponding to respective pixels PX. For example, in the display area DA, respective pixel areas PXA where the respective pixels PX are disposed may be defined.

In an embodiment, a barrier layer BRL may be provided on the substrate SUB. For example, the display panel 110 may further include the barrier layer BRL disposed between the substrate SUB and the panel circuit layer PCL. In another embodiment, the display panel 110 may not include the barrier layer BRL, and the panel circuit layer PCL may be disposed on (e.g., directly on) the substrate SUB.

The barrier layer BRL may include at least one inorganic layer including an inorganic insulating material (e.g., silicon nitride, silicon oxide, silicon oxynitride, titanium oxide, aluminium oxide, or other inorganic insulating materials). The barrier layer BRL may protect the pixels PX from moisture permeating through the substrate SUB vulnerable to moisture permeation. A material of the barrier layer BRL may be variously changed according to embodiments.

The panel circuit layer PCL may be disposed on one surface of the substrate SUB on which the barrier layer BRL is provided. The panel circuit layer PCL may include circuit elements including pixel transistors Tpx and pixel capacitors Cpx, and lines (e.g., signal lines and power lines).

The panel circuit layer PCL may further include insulating layers disposed on the substrate SUB. For example, the panel circuit layer PCL may include a first insulating layer INS1 (e.g., a buffer layer), a second insulating layer INS2 (e.g., a gate insulating layer), a third insulating layer INS3 (e.g., an interlayer insulating layer), and a first passivation layer PSV1 (e.g., a first protective layer and/or a first planarization layer) that are sequentially disposed on the substrate SUB along the third direction D3.

In an embodiment, the panel circuit layer PCL may further include the connection electrode CNE and the second passivation layer PSV2 (e.g., a second protective layer and/or a second planarization layer) that are disposed on the first passivation layer PSV1, as illustrated in FIG. 5. Alternatively, the panel circuit layer PCL may not include the connection electrode CNE and the second passivation layer PSV2 as illustrated in FIG. 6. In an embodiment of FIG. 6, one electrode of the second transistor T2 may be connected (e.g., directly connected) to an electrode of the light emitting element ED.

In an embodiment, at least one of the first passivation layer PSV1 and the second passivation layer PSV2 may have a multilayer structure including an inorganic film (e.g., an inorganic insulating layer) and an organic film (e.g., an organic insulating layer). For example, the first passivation layer PSV1 may include a first inorganic film IOL1 and a first organic film ORL1 that are sequentially disposed on the third insulating layer INS3, and the second passivation layer PSV2 may include a second inorganic film IOL2 and a second organic film ORL2 that are sequentially disposed on the first passivation layer PSV1.

In an embodiment, each of the first insulating layer INS1, the second insulating layer INS2, the third insulating layer INS3, the first inorganic film IOL1, and the second inorganic film IOL2 may include at least one inorganic insulating layer including an inorganic insulating material (e.g., silicon nitride, silicon oxide, silicon oxynitride, titanium oxide, aluminium oxide, or other inorganic insulating materials).

Each of the first organic film ORL1 and the second organic film ORL2 may include at least one organic insulating layer including an organic insulating material (e.g., an acrylic resin, an epoxy resin, a phenolic resin, a polyamide resin, a polyimide resin, or other organic insulating materials). Surfaces (e.g., upper surfaces) of the first organic film ORL1 and the second organic film ORL2 may be substantially flat. Types, materials, shapes, structures, and the like, of the insulating layers provided in the panel circuit layer PCL may be changed according to embodiments.

The pixel transistors Tpx may be included in the pixel circuit PC of each pixel PX, and may be positioned in the display area DA. For example, the first transistor T1 and the second transistor T2 provided to each pixel PX may be disposed in each pixel area PXA in which the corresponding pixel PX is positioned. In addition, at least one other pixel transistor Tpx, at least one pixel capacitor Cpx, and the like, may be further disposed in each pixel area PXA.

In an embodiment, at least one pixel transistor Tpx may include a bottom gate electrode BG. For example, the first transistor T1 may include a first bottom gate electrode BG1, and the second transistor T2 may include a second bottom gate electrode BG2. In an embodiment, the first bottom gate electrode BG1 and the second bottom gate electrode BG2 may be provided or formed in the same layer (e.g., a first conductive layer CDL1) within the panel circuit layer PCL.

The first transistor T1 may include the first bottom gate electrode BG1 disposed on the substrate SUB, a first active layer ACT1 (also referred to as a "first active pattern") disposed on the first bottom gate electrode BG1 and including a first channel region CH1, a first drain region DR1, and a first source region SR1, and a first gate electrode GE1 (hereinafter, referred to as a "first top gate electrode GE1") disposed on the first active layer ACT1. The first active layer ACT1 may be disposed on at least a portion of the first bottom gate electrode BG1. For example, at least a portion of the first active layer ACT1 including the first channel region CH1 may overlap the first bottom gate electrode BG1. The first top gate electrode GE1 may be disposed on a portion of the first active layer ACT1 including the first channel region CH1, and the second insulating layer INS2 may be disposed between the first top gate electrode GE1 and the first active layer ACT1.

In an embodiment, the first transistor T1 may further include a first drain electrode DE1 and a first source electrode SE1 connected to different portions of the first active layer ACT1. Alternatively, the first transistor T1 does not include a separate drain electrode and/or source electrode, and the first drain region DR1 and/or the first source region SR1 of the first active layer ACT1 may be connected to other circuit elements, lines, conductive patterns, and the like, to function as a drain electrode and/or a source electrode of the first transistor T1.

The first bottom gate electrode BG1 may be provided at or formed as the first conductive layer CDL1 on the substrate SUB. In an embodiment, the first conductive layer CDL1 may be disposed between the substrate SUB and the first insulating layer INS 1. For example, the first conductive layer CDL1 may be disposed on the barrier layer BRL, and may be covered by the first insulating layer INS1.

The first bottom gate electrode BG1 may overlap the first active layer ACT1. For example, the first bottom gate electrode BG1 may be disposed below the first active layer ACT1 so as to overlap at least the first channel region CH1. The first insulating layer INS1 may be disposed between the first bottom gate electrode BG1 and the first active layer ACT1. The first bottom gate electrode BG1 and the first active layer ACT1 may be spaced apart from each other by a distance corresponding to a thickness of the first insulating layer INS 1. The first bottom gate electrode BG1 may face the first top gate electrode GE1 with the first active layer ACT1 interposed therebetween.

The first bottom gate electrode BG1 may or may not be connected to another electrode of the first transistor T1. In an embodiment, the first bottom gate electrode BG1 may be electrically connected to the first top gate electrode GE1, and may be utilized as a back-gate electrode adjusting characteristics of the first transistor T1.

The first active layer ACT1 may be provided at or formed as a semiconductor layer SCL on the substrate SUB. In an embodiment, the semiconductor layer SCL may be disposed on the first insulating layer INS1, and may be covered by the second insulating layer INS2.

The first active layer ACT1 may include the first channel region CH1 overlapping the first top gate electrode GE1 and the first drain region DR1 and the first source region SR1 spaced apart from each other with the first channel region CH1 interposed therebetween. For example, the first drain region DR1 and the first source region SR1 may be positioned on both sides of the first channel region CH1, respectively. The first channel region CH1 may be a region that is not made to be conductive and maintains semiconductor characteristics, and the first drain region DR1 and the first source region SR1 may be regions made to be conductive.

The first active layer ACT1 may overlap the first bottom gate electrode BG1 and the first top gate electrode GE1. For example, the first channel region CH1 of the first active layer ACT1 may be disposed between the first bottom gate electrode BG1 and the first top gate electrode GE1, and may overlap the first bottom gate electrode BG1 and the first top gate electrode GE1.

The first active layer ACT1 may be covered (e.g., entirely covered) by the second insulating layer INS2. For example, the first active layer ACT1 may be covered by the second insulating layer INS2 except for a portion where at least one contact hole (e.g., a first contact hole CNT1 and a second contact hole CNT2) for connection to the first drain electrode DE1 and/or the first source electrode SE1 is formed. Accordingly, an amount of hydrogen introduced (or permeated) into the first active layer ACT1 in a forming process of the panel circuit layer PCL, or the like, may be reduced to appropriately control conductivity (e.g., a carrier concentration) of the first active layer ACT1 and/or a forming length of the first channel region CH1. In an embodiment, by adjusting a thickness of the second insulating layer INS2 covering a portion (e.g., the first drain region DR1 and the first source region SR1) of the first active layer ACT1 that does not overlap the first top gate electrode GE1, it is possible to adjust the conductivity of the first active layer ACT1 and/or the forming length of the first channel region CH1. For example, by reducing the thickness of the second insulating layer INS2 on the first drain region DR1 and the first source region SR1, it is possible to control the first drain region DR1 and the first source region SR1 to be appropriately made to be conductive without performing a separate doping process in the forming process of the panel circuit layer PCL.

In an embodiment, the first channel region CH1 may include a lower layer portion (e.g., a lower surface in contact with the first insulating layer INS1) adjacent to the first bottom gate electrode BG1 and an upper layer portion (e.g., an upper surface in contact with the second insulating layer INS2) adjacent to the first top gate electrode GE1. The lower layer portion of the first channel region CH1 may have a first length L1, and the upper layer portion of the first channel region CH1 may have a second length L2 greater than the first length L1. As an example, in a cross section of the first active layer ACT1, the first channel region CH1 may have an inverted trapezoidal shape of which a length (e.g., a channel length) increases from the lower layer portion toward the upper layer portion.

For example, in the first active layer ACT1, lengths and/or areas of regions made to be conductive (e.g., the first drain region DR1 and the first source region SR1) may be relatively smaller at the upper layer portion adjacent to the first top gate electrode GE1 than at the lower layer portion adjacent to the first bottom gate electrode BG1. Accordingly, the first channel region CH1 may have an expanded length and/or area at the upper layer portion compared to the lower layer portion.

In addition, the first channel region CH1 may have different carrier concentrations at the upper layer portion adjacent to the first top gate electrode GE1 and the lower layer portion adjacent to the first bottom gate electrode BG1. For example, the first channel region CH1 may have a higher carrier concentration at the lower layer portion than at the upper layer portion.

The first top gate electrode GE1 may be provided at a second conductive layer CDL2 on the substrate SUB. In an embodiment, the second conductive layer CDL2 may be disposed on the second insulating layer INS2, and may be covered by the third insulating layer INS3.

The first top gate electrode GE1 may be disposed on the first active layer ACT1 so as to overlap the first channel region CH1. The first top gate electrode GE1 and the first active layer ACT1 may be spaced apart from each other with the second insulating layer INS2 interposed therebetween.

In embodiments, the second insulating layer INS2 may have different thicknesses for each portion. For example, the second insulating layer INS2 may have a first thickness TH1 on a portion of the first active layer ACT1 including the first channel region CH1 and have a second thickness TH2 smaller than the first thickness TH1 on the remaining portion of the first active layer ACT1. As an example, the second insulating layer INS2 may have a first thickness TH1 locally at a portion (first portion of the second insulating layer INS2) interposed between the first channel region CH1 and the first top gate electrode GE1 and have a second thickness TH2 at the remaining portion including portions disposed on the first source region SR1 and the first drain region DR1. In describing embodiments, a portion of the second insulating layer INS2 having the first thickness TH1 will be referred to as a first portion of the second insulating layer INS2, and a portion of the second insulating layer INS2 having the second thickness TH2 will be referred to as a second portion of the second insulating layer INS2.

The first drain electrode DE1 and the first source electrode SE1 may be provided at a third conductive layer CDL3 on the substrate SUB. In an embodiment, the third conductive layer CDL3 may be disposed on the third insulating layer INS3.

The first drain electrode DE1 may be connected to a portion of the first active layer ACT1. For example, the first drain electrode DE1 may be connected to the first drain region DR1 through the first contact hole CNT1 penetrating through the second insulating layer INS2 and the third insulating layer INS3.

The first source electrode SE1 may be connected to another portion of the first active layer ACT1. For example, the first source electrode SE1 may be connected to the first source region SR1 through the second contact hole CNT2 penetrating through the second insulating layer INS2 and the third insulating layer INS3.

The second transistor T2 may include the second bottom gate electrode BG2 disposed on the substrate SUB, a second active layer ACT2 (also referred to as a "second active pattern") disposed on the second bottom gate electrode BG2 and including a second channel region CH2, a second drain region DR2, and a second source region SR2, and a second gate electrode GE2 (hereinafter, referred to as a "second top gate electrode GE2") disposed on the second active layer ACT2. The second active layer ACT2 may be disposed on at least a portion of the second bottom gate electrode BG2. For example, at least a portion of the second active layer ACT2 including the second channel region CH2 may overlap the second bottom gate electrode BG2. The second top gate electrode GE2 may be disposed on a portion of the second active layer ACT2 including the second channel region CH2, and the second insulating layer INS2 may be disposed between the second top gate electrode GE2 and the second active layer ACT2.

In an embodiment, the second transistor T2 may further include a second drain electrode DE2 and a second source electrode SE2 connected to different portions of the second active layer ACT2. Alternatively, the second transistor T2 does not include a separate drain electrode and/or source electrode, and the second drain region DR2 and/or the second source region SR2 of the second active layer ACT2 may be connected to other circuit elements, lines, conductive patterns, and the like, to function as a drain electrode and/or a source electrode of the second transistor T2.

The second bottom gate electrode BG2 may be provided at or formed as the first conductive layer CDL1 on the substrate SUB. For example, the second bottom gate electrode BG2 may be provided at the first conductive layer CDL1 together with the first bottom gate electrode BG1.

The second bottom gate electrode BG2 may overlap the second active layer ACT2. For example, the second bottom gate electrode BG2 may be disposed below the second active layer ACT2 so as to overlap at least the second channel region CH2. The first insulating layer INS1 may be disposed between the second bottom gate electrode BG2 and the second active layer ACT2. The second bottom gate electrode BG2 and the second active layer ACT2 may be spaced apart from each other by a distance corresponding to a thickness of the first insulating layer INS1. The second bottom gate electrode BG2 may face the second top gate electrode GE2 with the second active layer ACT2 interposed therebetween.

The second bottom gate electrode BG2 may or may not be connected to one electrode of the second transistor T2. In an embodiment, the second bottom gate electrode BG2 may be connected to the second source electrode SE2 of the second transistor T2, and may be utilized as a back-gate electrode adjusting characteristics of the second transistor T2.

The second active layer ACT2 may be provided at or formed as the semiconductor layer SCL on the substrate SUB. In an embodiment, the first active layer ACT1 and the second active layer ACT2 may be provided and/or disposed at the same layer (e.g., the same semiconductor layer SCL) on the substrate SUB, and may include the same oxide semiconductor.

The second active layer ACT2 may include the second channel region CH2 overlapping the second top gate electrode GE2 and the second drain region DR2 and the second source region SR2 spaced apart from each other with the second channel region CH2 interposed therebetween. For example, the second drain region DR2 and the second source region SR2 may be positioned on both sides of the second channel region CH2, respectively. The second channel region CH2 may be a region that is not made to be conductive and maintains semiconductor characteristics, and the second drain region DR2 and the second source region SR2 may be regions made to be conductive.

The second active layer ACT2 may overlap the second bottom gate electrode BG2 and the second top gate electrode GE2. For example, the second channel region CH2 of the second active layer ACT2 may be disposed between the second bottom gate electrode BG2 and the second top gate electrode GE2, and may overlap the second bottom gate electrode BG2 and the second top gate electrode GE2.

The second active layer ACT2 may be covered (e.g., entirely covered) by the second insulating layer INS2. For example, the second active layer ACT2 may be covered by the second insulating layer INS2 except for a portion where at least one contact hole (e.g., a third contact hole CNT3 and a fourth contact hole CNT4) for connection to the second drain electrode DE2 and/or the second source electrode SE2 is formed. Accordingly, an amount of hydrogen introduced (or permeated) into the second active layer ACT2 in the forming process of the panel circuit layer PCL, or the like, may be reduced to appropriately control conductivity (e.g., a carrier concentration) of the second active layer ACT2 and/or a forming length of the second channel region CH2. In an embodiment, by adjusting a thickness of the second insulating layer INS2 covering a portion (e.g., the second drain region DR2 and the second source region SR2) of the second active layer ACT2 that does not overlap the second top gate electrode GE2, it is possible to adjust the conductivity of the second active layer ACT2 and/or the forming length of the second channel region CH2.

In an embodiment, the second channel region CH2 may include a lower layer portion (e.g., a lower surface in contact with the first insulating layer INS1) adjacent to the second bottom gate electrode BG2 and an upper layer portion adjacent to the second bottom gate electrode BG2. The upper layer of the second channel region CH2 may have a greater length than the lower layer portion of the second channel region CH2. As an example, in a cross section of the second active layer ACT2, the second channel region CH2 may have an inverted trapezoidal shape of which a length (e.g., a channel length) increases from the lower layer portion toward the upper layer portion.

For example, in the second active layer ACT2, lengths and/or areas of regions made to be conductive (e.g., the second drain region DR2 and the second source region SR2) may be relatively smaller at the upper layer portion adjacent to the second top gate electrode GE2 than at the lower layer portion adjacent to the second bottom gate electrode BG2. Accordingly, the second channel region CH2 may have an expanded length and/or area at the upper layer portion compared to the lower layer portion.

In addition, the second channel region CH2 may have different carrier concentrations at the upper layer portion adjacent to the second top gate electrode GE2 and the lower layer portion adjacent to the second bottom gate electrode BG2. For example, the second channel region CH2 may have a higher carrier concentration at the lower layer portion than at the upper layer portion.

The second top gate electrode GE2 may be provided at or formed as the second conductive layer CDL2 on the second insulating layer INS2. For example, the second top gate electrode GE2 may be provided and/or disposed at the same layer as the first top gate electrode GE1 on the substrate SUB.

The second top gate electrode GE2 may be disposed on the second active layer ACT2 so as to overlap the second channel region CH2. The second top gate electrode GE2 and the second active layer ACT2 may be spaced apart from each other with the second insulating layer INS2 interposed therebetween.

In an embodiment, the second insulating layer INS2 may have different thicknesses for each portion on the second active layer ACT2. For example, the second insulating layer INS2 may have a relatively great thickness on a portion of the second active layer ACT2 including the second channel region CH2 and have a relatively small thickness on the remaining portion of the second active layer ACT2. As an example, the second insulating layer INS2 may have a first thickness TH1 locally at a portion interposed between the second channel region CH2 and the second top gate electrode GE2 and have a second thickness TH2 at the remaining portion including portions disposed on the second source region SR2 and the second drain region DR2.

In an embodiment, the second insulating layer INS2 may be entirely formed in the pixel area PXA and/or the display area DA including the pixel area PXA so as to cover the active layers of the pixel transistors Tpx provided at the semiconductor layer SCL.

In an embodiment, the second insulating layer INS2 may be etched by a partial thickness (e.g., half-etched) at portions that do not overlap top gates of transistors using the same mask as a mask used in a step of patterning top gate electrodes provided at or formed as the second conductive layer CDL2 including the first top gate electrode GE1 and the second top gate electrode GE2 (e.g., top gate electrodes of transistors provided at the panel circuit layer PCL including the pixel transistors Tpx) or using the top gate electrodes as a mask. Accordingly, the second insulating layer INS2 may have different thicknesses at the first portion overlapping the top gates of the transistors and the second portion corresponding to the remaining portion.

In addition, the second insulating layer INS2 may have a pattern shape and/or size corresponding to each top gate electrode at an upper layer portion (e.g., an upper surface of the first portion having the first thickness TH1) in contact with each top gate electrode. For example, the second insulating layer INS2 may have substantially the same pattern shape as the first top gate electrode GE1 (e.g., the same pattern shape as a lower surface of the first top gate electrode GE1) at the upper layer portion in contact with the first top gate electrode GE1, and may have substantially the same area as the first top gate electrode GE1 (e.g., the same area as the lower surface of the first top gate electrode GE1). Accordingly, a sudden change in length or width may not occur at a boundary between the first top gate electrode GE1 and the second insulating layer INS2, and a side surface of the first top gate electrode GE1 and a side surface of the second insulating layer INS2 may have an inclined surface having a continuously connected form. For example, the side surface of the first top gate electrode GE1 and the side surface of the second insulating layer INS2 may be coplanar with each other. The second insulating layer INS2 may have substantially the same pattern shape as the second top gate electrode GE2 (e.g., the same pattern shape as a lower surface of the second top gate electrode GE2) at the upper layer portion in contact with the second top gate electrode GE2, and may have substantially the same area as the second top gate electrode GE2 (e.g., the same area as the lower surface of the second top gate electrode GE2). Accordingly, a sudden change in length or width may not occur at a boundary between the second top gate electrode GE2 and the second insulating layer INS2, and a side surface of the second top gate electrode GE2 and a side surface of the second insulating layer INS2 may have an inclined surface having a continuously connected form. For example, the side surface of the second top gate electrode GE2 and the side surface of the second insulating layer INS2 may be coplanar with each other.

In an embodiment, the second insulating layer INS2 may be formed in a shape in which it is etched by a partial thickness (e.g., in a half-etched shape) at the second portion except for the first portion below each top gate electrode, and may have a step portion having a stair shape at the boundary between the first portion and the second portion. The second conductive layer CDL2 including the first top gate electrode GE1, the second top gate electrode GE2, and the like, and the second insulating layer INS2 may be covered with the third insulating layer INS3.

The second drain electrode DE2 and the second source electrode SE2 may be provided at or formed as the third conductive layer CDL3 on the substrate SUB. For example, the second drain electrode DE2 and the second source electrode SE2 may be disposed on the third insulating layer INS3, and may be covered by the first passivation layer PSV1.

The second drain electrode DE2 may be connected to a portion of the second active layer ACT2. For example, the second drain electrode DE2 may be connected to the second drain region DR2 through the third contact hole CNT3 penetrating through the second insulating layer INS2 and the third insulating layer INS3.

The second source electrode SE2 may be connected to another portion of the second active layer ACT2. For example, the second source electrode SE2 may be connected to the second source region SR2 through the fourth contact hole CNT4 penetrating through the second insulating layer INS2 and the third insulating layer INS3. In an embodiment, the second source electrode SE2 may be further connected to the second bottom gate electrode BG2. For example, the second source electrode SE2 may be connected to the second bottom gate electrode BG2 through a fifth contact hole CNT5 penetrating through the first insulating layer INS1, the second insulating layer INS2 and the third insulating layer INS3.

The pixel transistors Tpx including the first transistor T1 and the second transistor T2 may be covered by at least one passivation layer. For example, the pixel transistors Tpx may be covered by the first passivation layer PSV1 and the second passivation layer PSV2 as illustrated in FIG. 5 or be covered by the first passivation layer PSV1 as illustrated in FIG. 6.

In an embodiment of FIG. 5, the second transistor T2 of each pixel PX may be connected to the light emitting element ED of the corresponding pixel PX through the connection electrode CNE. The connection electrode CNE may be provided at or formed as a fourth conductive layer CDL4 on the substrate SUB. In an embodiment, the fourth conductive layer CDL4 may be disposed on the first passivation layer PSV1, and may be covered by the second passivation layer PSV2. For example, the fourth conductive layer CDL4 may be disposed between the first passivation layer PSV1 and the second passivation layer PSV2. In the case that the display panel 110 further includes the fourth conductive layer CDL4, the number of conductive layers provided in the display panel 110 may increase. Accordingly, a design space for forming various conductive patterns (e.g., electrodes and/or bridge patterns), lines, or the like, within the display panel 110 may be sufficiently ensured. Accordingly, even when the display panel 110 is formed at high resolution, the pixel circuits PC, the lines, and the like, may be easily and/or appropriately formed.

The connection electrode CNE may be connected to one electrode of the second transistor T2. As an example, the connection electrode CNE may be disposed above the second source electrode SE2 and be connected to the second source electrode SE2 through at least one contact hole or via hole penetrating through the first passivation layer PSV1.

In an embodiment of FIG. 6, the second transistor T2 of each pixel PX may be connected to the light emitting element ED of the corresponding pixel PX not through the connection electrode CNE. For example, the second source electrode SE2 of each pixel PX may be directly connected to the light emitting element ED of the corresponding pixel PX.

Each of the electrodes, the conductive patterns, and/or the lines provided at or formed as the conductive layers of the panel circuit layer PCL may include at least one conductive material, and may have a single-layer or multilayer structure. For example, each of the electrodes, the conductive patterns, and/or the lines provided at or formed as each of the first conductive layer CDL1, the second conductive layer CDL2, the third conductive layer CDL3, and the fourth conductive layer CDL4 may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), and other metals, alloys thereof, or other conductive materials, and may have a single-layer or multilayer structure. In an embodiment, the electrodes, the conductive patterns, and/or the lines disposed at the same conductive layer may be formed simultaneously using the same conductive material.

In an embodiment, the active layers provided at or formed as the semiconductor layer SCL may include an oxide semiconductor. For example, each of the first active layer ACT1 and the second active layer ACT2 may include at least one of zinc oxide (ZnO), zinc tin oxide (ZTO), indium zinc oxide (IZO), indium oxide (InO), titanium oxide (TiO), indium gallium oxide (IGO), indium gallium zinc oxide (IGZO), indium gallium tin oxide (IGTO), indium zinc tin oxide (IZTO), indium tin gallium zinc oxide (ITGZO), or other oxide semiconductors. The oxide semiconductor used to form the oxide transistors including the first transistor T1 and the second transistor T2 is not limited to the materials exemplified above, and may be changed according to embodiments.

In an embodiment, the active layers provided at or formed as the same semiconductor layer SCL may include the same oxide semiconductor. For example, the first active layer ACT1 and the second active layer ACT2 may be formed simultaneously using the same oxide semiconductor.

In an embodiment, the active layers of the pixel transistors Tpx may be made of a high-mobility oxide semiconductor (e.g., a high-mobility (e.g., mobility of approximately 50 cm²/Vs or more)) oxide semiconductor with a high electron concentration) such as indium tin gallium zinc oxide (ITGZO) or indium gallium oxide (IGO). When the pixel transistors Tpx are made of the high-mobility oxide semiconductor, it is possible to appropriately ensure mobility or the like of each transistor while forming each transistor in a minute size (e.g., a size including an active layer having a width and/or a length in the range of approximately several micrometers to tens of micrometers). Accordingly, even in a high-resolution display device in which an area of the pixel area PXA is relatively small, the pixel transistors Tpx may be easily disposed and/or formed, and element characteristics and/or operation characteristics of the pixel transistors Tpx may be appropriately ensured. For example, even though a channel length of at least one switching transistor provided to the pixel PX is reduced, operation characteristics (e.g., appropriate switching characteristics) of the switching transistor may be ensured. Accordingly, an area occupied by the pixel transistors Tpx may be appropriately and/or easily reduced, and a design space for other circuit elements, lines, or the like, may be ensured. In addition, the pixel transistors Tpx are made of the high-mobility oxide semiconductor, such that power consumption of the display device 100 may be reduced.

The light emitting element layer LEL may be disposed on the panel circuit layer PCL, and may be positioned in the display area DA. For example, the light emitting element layer LEL may be disposed on the panel circuit layer PCL in the display area DA.

The light emitting element layer LEL may include the light emitting elements ED of the pixels PX. For example, the light emitting element layer LEL may include a pixel defining layer PDL (also referred to as a "bank") partitioning or defining an emission area of each of the pixels PX and the light emitting element ED positioned in each emission area. In an embodiment, the light emitting element layer LEL may further include a spacer SPC disposed on a portion of the pixel defining layer PDL.

Each light emitting element ED may include a first electrode ET1 (e.g., an anode electrode) connected to at least one pixel transistor Tpx (e.g., the second transistor T2) included in a corresponding pixel PX, and a light emitting layer EML and a second electrode ET2 (e.g., a cathode electrode) that are sequentially disposed on the first electrode ET1. In an embodiment, the light emitting element ED may further include a first intermediate layer (e.g., a hole layer including a hole transporting layer) interposed between the first electrode ET1 and the light emitting layer EML and a second intermediate layer (e.g., an electron layer including an electron transporting layer) interposed between the light emitting layer EML and the second electrode ET2.

The first electrode ET1 of the light emitting element ED may be disposed on the panel circuit layer PCL. In an embodiment of FIG. 5, the first electrode ET1 may be disposed on the second passivation layer PSV2 so as to correspond to each emission area, and may be connected to the connection electrode CNE through at least one contact hole or via hole penetrating through the second passivation layer PSV2. In an embodiment of FIG. 6, the first electrode ET1 may be disposed on the first passivation layer PSV1 so as to correspond to each emission area, and may be directly connected to at least one pixel transistor Tpx.

The first electrode ET1 may include a conductive material. In an embodiment, the first electrode ET1 may include a metal material having high reflectivity. For example, the first electrode ET1 may have a single-layer structure of molybdenum (Mo), titanium (Ti), copper (Cu), or aluminium (Al) or have a multilayer structure (e.g., ITO/Mg, ITO/MgF, ITO/Ag, ITO/Ag/ITO, etc.) including indium tin oxide (ITO), indium zinc oxide (IZO), zinc oxide (ZnO), or indium oxide (In₂O₃), and silver (Ag), magnesium (Mg), aluminium (Al), platinum (Pt), lead (Pb), gold (Au), nickel (Ni), or the like.

The light emitting layer EML of the light emitting element ED may include a polymer material or a low molecular material. Light emitted from the light emitting layer EML may contribute to image display. In an embodiment, the light emitting layer EML may be provided for each pixel PX, and the light emitting layer EML of each pixel PX may emit visible light of a color corresponding to the corresponding pixel PX. In another embodiment, the light emitting layer EML may be a common layer shared by the pixels PX of different colors, and wavelength conversion layers and/or color filters corresponding to colors (or wavelength bands) of light to be emitted from the respective pixels PX may be disposed in the emission areas of at least some of the pixels PX.

The second electrode ET2 of the light emitting element ED may include a conductive material. In an embodiment, the second electrode ET2 may be a common film formed over the entire display area DA in a form in which it covers the light emitting layer EML and the pixel defining layer PDL. In an embodiment, the second electrode ET2 may be made of a transparent conductive material (TCO) such as ITO, IZO, ZnO, or ITZO capable of transmitting light therethrough or a semi-transmissive conductive material such as magnesium (Mg), silver (Ag), or an alloy of magnesium (Mg) and silver (Ag).

The pixel defining layer PDL may have an opening corresponding to each emission area and may surround each emission area. For example, the pixel defining layer PDL may be formed to cover an edge of the first electrode ET1 of the light emitting element ED, and may include an opening exposing the remaining portion of the first electrode ET1. An area in which the exposed first electrode ET1 and the light emitting layer EML overlap each other (or an area including such an area) may be defined as the emission area of each pixel PX.

In an embodiment, the pixel defining layer PDL may include at least one organic layer including an organic insulating material. For example, the pixel defining layer PDL may include an acrylic resin, an epoxy resin, a phenolic resin, a polyamides resin, a polyimides resin, an unsaturated polyesters resin, a polyphenyleneethers resin, a polyphenylenesulfides resin, benzocyclobutene (BCB), or other organic insulating materials.

The spacer SPC may be disposed on a portion of the pixel defining layer PDL. The spacer SPC may include at least one organic layer including an organic insulating material. The spacer SPC may include the same material as the pixel defining layer PDL or include a different material from the pixel defining layer PDL. In an embodiment, the pixel defining layer PDL and the spacer SPC may be sequentially formed through respective mask processes. In another embodiment, the pixel defining layer PDL and the spacer SPC may be formed simultaneously using a halftone mask. In this case, the pixel defining layer PDL and the spacer SPC may be regarded as a single insulating film integral with each other.

The encapsulation layer ENL may be disposed on the light emitting element layer LEL. The encapsulation layer ENL may cover the light emitting element layer LEL in the display area DA and extend to the non-display area NDA to be in contact with the panel circuit layer PCL. For example, the encapsulation layer ENL may be disposed in the display area DA so as to cover the light emitting element layer LEL, and an end of the encapsulation layer ENL may be positioned in a portion of the non-display area NDA adjacent to the display area DA. The encapsulation layer ENL may block permeation of oxygen or moisture into the light emitting element layer LEL and alleviate or reduce electrical or physical shock to the panel circuit layer PCL and the light emitting element layer LEL.

In an embodiment, the encapsulation layer ENL may have a multilayer structure including a first encapsulation layer ENL1, a second encapsulation layer ENL2, and a third encapsulation layer ENL3 that are sequentially disposed on the light emitting element layer LEL. Each of the first encapsulation layer ENL1 and the third encapsulation layer ENL3 may be an inorganic encapsulation layer including an inorganic material. The second encapsulation layer ENL2 may be an organic encapsulation layer including an organic material. A structure and/or a material of the encapsulation layer ENL may be changed according to embodiments.

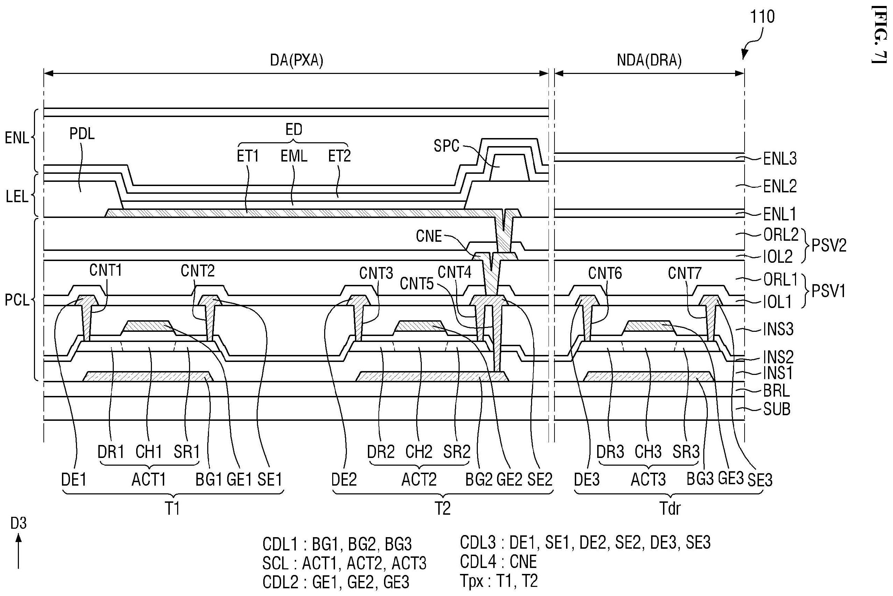

FIG. 7 is a cross-sectional view illustrating the display panel 110 according to an embodiment. For example, FIG. 7 illustrates the display area DA and a portion of the non-display area NDA of the display panel 110. FIG. 7 illustrates the first transistor T1 and the second transistor T2 according to an embodiment of FIG. 5 as an example of circuit elements that may be provided or disposed in the display area DA of the panel circuit layer PCL, and illustrates any one driver transistor Tdr provided or disposed in a driving circuit area DRA as an example of additional circuit elements that may be provided in the panel circuit layer PCL.

Referring to FIG. 7 in addition to FIGS. 1 to 6, the display panel 110 may further include driver transistors Tdr disposed in the driving circuit area DRA. For example, the display panel 110 may further include a plurality of driver transistors Tdr provided in the first driver 120 and disposed in the driving circuit area DRA corresponding to a portion of the non-display area NDA. FIG. 7 illustrates only one driver transistor Tdr representative of the driver transistors Tdr.

The substrate SUB and the display panel 110 including the substrate SUB may include a display area DA and a non-display area NDA. In an embodiment, the non-display area NDA may include the driving circuit area DRA. For example, the driving circuit area DRA in which the first driver 120 is disposed may be defined in the non-display area NDA.

The panel circuit layer PCL may further include the driver transistors Tdr in addition to the pixel transistors Tpx. The driver transistors Tdr may be disposed in stage areas positioned in the driving circuit area DRA (e.g., respective stage areas in which stage circuits of a shift register constituting the first driver 120 are provided).

In an embodiment, at least one driver transistor Tdr may be a transistor having a double gate structure including a bottom gate electrode BG. In describing embodiments, the bottom gate electrode BG provided to the driver transistor Tdr will be referred to as a "third bottom gate electrode BG3". In an embodiment, the third bottom gate electrode BG3 provided to at least one driver transistor Tdr may be connected to another electrode (e.g., a gate electrode) of the corresponding driver transistor Tdr.

However, embodiments are not limited thereto. For example, the driver transistors Tdr may not include respective bottom gate electrodes BG.

The driver transistor Tdr may include the third bottom gate electrode BG3 disposed on the substrate SUB, a third active layer ACT3 (also referred to as a "third active pattern") disposed on the first insulating layer INS1 on the third bottom gate electrode BG3 and including a third channel region CH3, a third drain region DR3, and a third source region SR3, and a third gate electrode GE3 (hereinafter, referred to as a "third top gate electrode GE3") disposed on the second insulating layer INS2 on the third active layer ACT3. The third active layer ACT3 may be disposed on at least a portion of the third bottom gate electrode BG3. For example, at least a portion of the third active layer ACT3 including the third channel region CH3 may overlap the third bottom gate electrode BG3. The third top gate electrode GE3 may be disposed on a portion of the third active layer ACT3 including the third channel region CH3.

In an embodiment, the driver transistor Tdr may further include a third drain electrode DE3 and a third source electrode SE3 connected to different portions of the third active layer ACT3. Alternatively, the driver transistor Tdr does not include a separate drain electrode and/or source electrode, and the third drain region DR3 and/or the third source region SR3 of the third active layer ACT3 may be connected to other circuit elements, lines, conductive patterns, and the like, to function as a drain electrode and/or a source electrode of the driver transistor Tdr.

The third bottom gate electrode BG3 may be provided at or formed as the first conductive layer CDL1 on the substrate SUB. For example, the third bottom gate electrode BG3 may be provided at the first conductive layer CDL1 together with the first bottom gate electrode BG1 and the second bottom gate electrode BG2.

The third bottom gate electrode BG3 may overlap the third active layer ACT3. For example, the third bottom gate electrode BG3 may be disposed below the third active layer ACT3 so as to overlap at least the third channel region CH3. The first insulating layer INS1 may be disposed between the third bottom gate electrode BG3 and the third active layer ACT3. The third bottom gate electrode BG3 and the third active layer ACT3 may be spaced apart from each other by a distance corresponding to a thickness of the first insulating layer INS1. The third bottom gate electrode BG3 may face the third top gate electrode GE3 with the third active layer ACT3 interposed therebetween.

The third bottom gate electrode BG3 may or may not be connected to one electrode of the driver transistor Tdr. In an embodiment, the third bottom gate electrode BG3 may be connected to the third top gate electrode GE3 of the driver transistor Tdr, and may be utilized as a back-gate electrode adjusting characteristics of the driver transistor Tdr.

The third active layer ACT3 may be provided at or formed as the semiconductor layer SCL on the substrate SUB. In an embodiment, the first active layer ACT1, the second active layer ACT2, and the third active layer ACT3 may be provided and/or disposed at the same layer (e.g., the same semiconductor layer SCL) on the substrate SUB.

In an embodiment, the third active layer ACT3 may include the same oxide semiconductor as the first active layer ACT1 and/or the second active layer ACT2, and may be formed simultaneously with the first active layer ACT1 and/or the second active layer ACT2. For example, the first active layer ACT1, the second active layer ACT2, and the third active layer ACT3 may include the same oxide semiconductor.

The third active layer ACT3 may include the third channel region CH3 overlapping the third top gate electrode GE3 and the third drain region DR3 and the third source region SR3 spaced apart from each other with the third channel region CH3 interposed therebetween. For example, the third drain region DR3 and the third source region SR3 may be positioned on both sides of the third channel region CH3, respectively. The third channel region CH3 may be a region that is not made to be conductive and maintains semiconductor characteristics, and the third drain region DR3 and the third source region SR3 may be regions made to be conductive.

The third active layer ACT3 may overlap the third bottom gate electrode BG3 and the third top gate electrode GE3. For example, the third channel region CH3 of the third active layer ACT3 may be disposed between the third bottom gate electrode BG3 and the third top gate electrode GE3, and may overlap the third bottom gate electrode BG3 and the third top gate electrode GE3.

The third active layer ACT3 may be covered (e.g., entirely covered) by the second insulating layer INS2. For example, the third active layer ACT3 may be covered by the second insulating layer INS2 except for a portion where at least one contact hole (e.g., a sixth contact hole CNT6 and a seventh contact hole CNT7) for connection to the third drain electrode DE3 and/or the third source electrode SE3 is formed. Accordingly, an amount of hydrogen introduced (or permeated) into the third active layer ACT3 in the forming process of the panel circuit layer PCL, or the like, may be reduced to appropriately control conductivity of the third active layer ACT3 and/or a forming length of the third channel region CH3. In an embodiment, by adjusting a thickness of the second insulating layer INS2 covering a portion (e.g., the third drain region DR3 and the third source region SR3) of the third active layer ACT3 that does not overlap the third top gate electrode GE3, it is possible to adjust the conductivity of the third active layer ACT3 and/or the forming length of the third channel region CH3.

In an embodiment, the third channel region CH3 may include a lower layer portion (e.g., a lower surface in contact with the first insulating layer INS1) adjacent to the third bottom gate electrode BG3 and an upper layer portion adjacent to the third top gate electrode GE3. The upper layer portion of the third channel region CH3 may have a greater length than the lower layer portion of the third channel region CH3. As an example, in a cross section of the third active layer ACT3, the third channel region CH3 may have an inverted trapezoidal shape of which a length (e.g., a channel length) increases from the lower layer portion toward the upper layer portion.

For example, in the third active layer ACT3, lengths and/or areas of regions made to be conductive (e.g., the third drain region DR3 and the third source region SR3) may be relatively smaller at the upper layer portion adjacent to the third top gate electrode GE3 than at the lower layer portion adjacent to the third bottom gate electrode BG3. Accordingly, the third channel region CH3 may have an expanded length and/or area at the upper layer portion compared to the lower layer portion.

In addition, the third channel region CH3 may have different carrier concentrations at the upper layer portion adjacent to the third top gate electrode GE3 and the lower layer portion adjacent to the third bottom gate electrode BG3. For example, the third channel region CH3 may have a higher carrier concentration at the lower layer portion than at the upper layer portion.

The third top gate electrode GE3 may be provided at the second conductive layer CDL2 on the substrate SUB. In an embodiment, the first top gate electrode GE1, the second top gate electrode GE2, and the third top gate electrode GE3 may be provided and/or disposed at the same layer on the substrate SUB, and may be formed simultaneously.

The third top gate electrode GE3 may be disposed on the third active layer ACT3 so as to overlap the third channel region CH3. The third top gate electrode GE3 and the third active layer ACT3 may be spaced apart from each other with the second insulating layer INS2 interposed therebetween.

In an embodiment, the second insulating layer INS2 may have different thicknesses for each portion on the third active layer ACT3. For example, the second insulating layer INS2 may have a relatively great thickness on a portion of the third active layer ACT3 including the third channel region CH3 and have a relatively small thickness on the remaining portion of the third active layer ACT3. As an example, the second insulating layer INS2 may have a first thickness TH1 locally at a portion interposed between the third channel region CH3 and the third top gate electrode GE3 and have a second thickness TH2 at the remaining portion including portions disposed on the third source region SR3 and the third drain region DR3.

In an embodiment, the second insulating layer INS2 may be entirely formed in the display area DA and the driving circuit area DRA so as to cover the active layers of the pixel transistors Tpx and the driver transistors Tdr provided at the semiconductor layer SCL.

In an embodiment, the second insulating layer INS2 may be etched by a partial thickness at portions that do not overlap top gates of transistors using the same mask as a mask used in a step of patterning top gate electrodes provided at the second conductive layer CDL2 (e.g., top gate electrodes of transistors provided at the panel circuit layer PCL including the pixel transistors Tpx and the driver transistors Tdr) or using the top gate electrodes as a mask. Accordingly, the second insulating layer INS2 may have different thicknesses at the first portion overlapping the top gates of the transistors and the second portion corresponding to the remaining portion.

In addition, the second insulating layer INS2 may have a pattern shape and/or size corresponding to each top gate electrode at an upper layer portion in contact with each top gate electrode. For example, the second insulating layer INS2 may have substantially the same pattern shape as the third top gate electrode GE3 (e.g., the same pattern shape as a lower surface of the third top gate electrode GE3) at the upper layer portion in contact with the third top gate electrode GE3, and may have substantially the same area as the third top gate electrode GE3 (e.g., the same area as the lower surface of the third top gate electrode GE3). Accordingly, a sudden change in length or width may not occur at a boundary between the third top gate electrode GE3 and the second insulating layer INS2, and a side surface of the third top gate electrode GE3 and a side surface of the second insulating layer INS2 may have an inclined surface having a continuously connected form. For example, the side surface of the third top gate electrode GE3 and the side surface of the second insulating layer INS2 may be coplanar with each other.

The third drain electrode DE3 and the third source electrode SE3 may be provided at the third conductive layer CDL3 on the substrate SUB. In an embodiment, the third drain electrode DE3 and the third source electrode SE3 may be disposed at the same layer as the first and second drain electrodes DE1 and DE2 and the first and second source electrodes SE1 and SE2 on the substrate SUB. For example, the third drain electrode DE3 and the third source electrode SE3 may be disposed on the third insulating layer INS3, and may be covered by the first passivation layer PSV1.

The third drain electrode DE3 may be connected to a portion of the third active layer ACT3. For example, the third drain electrode DE3 may be connected to the third drain region DR3 through the sixth contact hole CNT6 penetrating through the second insulating layer INS2 and the third insulating layer INS3.

The third source electrode SE3 may be connected to another portion of the third active layer ACT3. For example, the third source electrode DE3 may be connected to the third source region SR3 through the seventh contact hole CNT7 penetrating through the second insulating layer INS2 and the third insulating layer INS3.

The transistors provided in the panel circuit layer PCL may be covered by at least the first passivation layer PSV1. As an example, the pixel transistors Tpx and the driver transistors Tdr may be covered by the first passivation layer PSV1 and the second passivation layer PSV2.

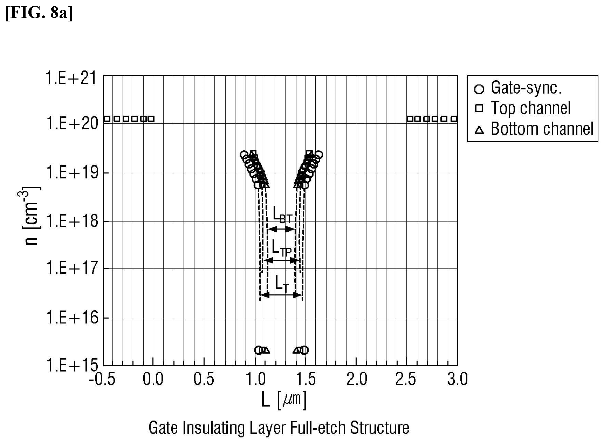

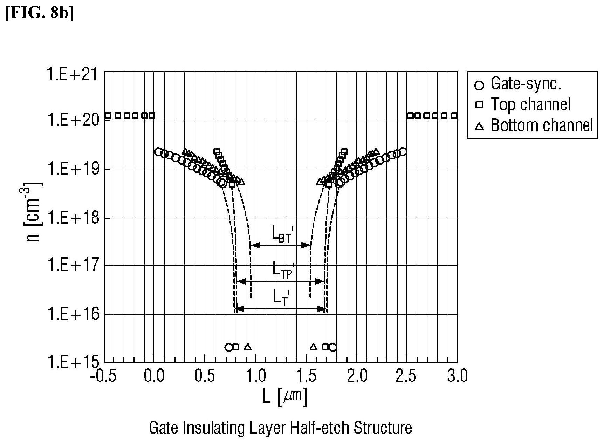

FIGS. 8a and 8b are graphs illustrating an effective channel length of a channel region formed in a transistor according to an etching degree of a gate insulating layer. For example, FIGS. 8a and 8b illustrate a carrier concentration measured in a channel region according to an etching degree of a gate insulating layer and an effective channel length according to the carrier concentration, in a transistor having a gate-sync. structure in which a length of the channel region is 2.5 µm (e.g., a transistor having a double gate structure in which a bottom gate electrode is connected to a top gate electrode). The gate insulating layer of FIGs. 8a and 8b may be a component corresponding to the second insulating layer INS2 disclosed in embodiments of FIGS. 5 to 7.

Referring to FIGS. 8a and 8b in addition to FIGS. 1 to 7, the effective channel length of the channel region formed in the transistor may be changed depending on the etching degree of the gate insulating layer. For example, FIG. 8a illustrates a carrier concentration of a channel region measured in a transistor having a gate-sync. structure in which a gate insulating layer is etched by a full thickness on a drain region and a source region so as to expose the drain region and the source region excluding the channel region of an active layer, and an effective channel length of the channel region according to the carrier concentration. On the other hand, FIG. 8b illustrates a carrier concentration of a channel region measured in a transistor having a gate-sync. structure in which an active layer is covered (e.g., entirely covered) by a gate insulating layer by etching the gate insulating layer by a partial thickness on a drain region and a source region as in embodiments of FIGS.5 to 7, and an effective channel length of the channel region according to the carrier concentration. In FIGS. 8a and 8b, a numerical value on a horizontal axis indicates a position in the channel region, a point corresponding to 0 may be a starting point of the channel region, and a point corresponding to 2.5 may be an end point of the channel region. For example, a section having a length of 2.5 µm between a point marked as 0 and a point marked as 2.5 based on the horizontal axis may correspond to the channel region. In FIGS. 8a and 8b, a vertical axis indicates a concentration of electrons (n) corresponding to carriers.

Comparing FIGS. 8a and 8b with each other, the effective channel length formed in the channel region of the transistor may be extended by etching the gate insulating layer only by the partial thickness instead of etching the insulating layer by a full thickness. For example, in a transistor in which the gate insulating layer is etched by the full thickness, excessive amounts of hydrogen are introduced (or permeated) into the source region, the drain region, and the like, in a manufacturing process of the display panel 110, such that an amount of hydrogen diffused into the channel region (e.g., diffused laterally) may increase. Accordingly, an effective channel length L_{BT} of a bottom channel formed at a lower layer portion of the channel region, an effective channel length L_{TP} of a top channel formed at an upper layer portion of the channel region, and a total effective channel length L_{T} will become relatively short. On the other hand, in a transistor having the same size in which the gate insulating layer is etched only by the partial thickness, amounts of hydrogen introduced (or permeated) into the source region, the drain region, and the like, are reduced, such that an amount of hydrogen diffused into the channel region may be reduced. Accordingly, an effective channel length L_{BT}' of a bottom channel formed at a lower layer portion of the channel region, an effective channel length L_{TP}' of a top channel formed at an upper layer portion of the channel region, and a total effective channel length L_{T}' will become relatively long. In particular, in the transistor in which the gate insulating layer is etched only by the partial thickness, the effective channel length L_{TP}' of the top channel may significantly increase by reducing an amount of hydrogen introduced (or permeated) from an upper portion of the active layer. Accordingly, the total effective channel length L_{T}' of the transistor may increase.

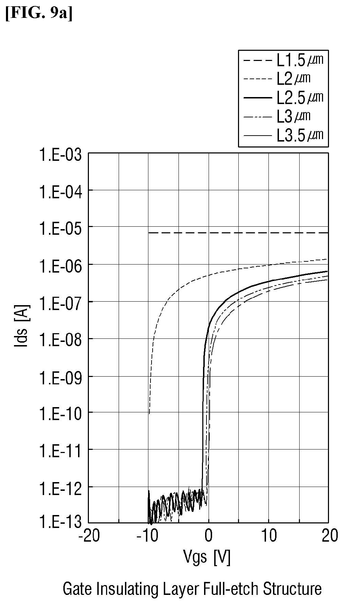

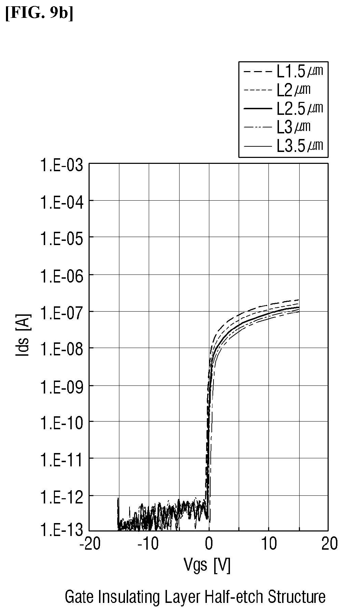

FIGS. 9a and 9b are graphs illustrating a change in characteristics of a transistor according to an etching degree of a gate insulating layer. For example, FIGS. 9a and 9b illustrate electrical characteristics of each transistor according to an etching degree of a gate insulating layer in transistors having a gate-sync. structure in which lengths of channel regions are 1.5 µm, 2 µm, 2.5 µm, 3 µm, and 3.5 µm, respectively, through a drain-source current Ids according to a gate-source voltage Vgs. The gate insulating layer of FIG. 9a and 9b may be a component corresponding to the second insulating layer INS2 disclosed in embodiments of FIGS. 5 to 7.

Referring to FIGS. 9a and 9b in addition to FIGS. 1 to 7 and FIGS. 8a and 8b, in the transistor in which the gate insulating layer is etched by a full thickness, when a length of the channel region is reduced, threshold voltage roll-off (Vth roll-off) of the transistor occurs, such that operation characteristics of the transistor may deteriorate. For example, when the length of the channel region is smaller than 2.5 µm, the transistor may not exhibit operation characteristics suitable as the pixel transistor Tpx and/or the driver transistor Tdr. As an example, in the transistor in which the length of the channel region is 1.5 µm, threshold voltage roll-off (Vth roll-off) may occur, and the transistor may substantially operate like a conductor.

On the other hand, in the transistor in which the gate insulating layer is etched only by the partial thickness as in embodiments of FIGS. 5 to 7, even though the length of the channel region is reduced, threshold voltage roll-off (Vth roll-off) of the transistor may be prevented, and operation characteristics of the transistor may be improved. For example, even though a transistor is the transistor in which the length of the channel region is smaller than 2.5 µm, the transistor may exhibit operation characteristics suitable as the pixel transistor Tpx and/or the driver transistor Tdr.

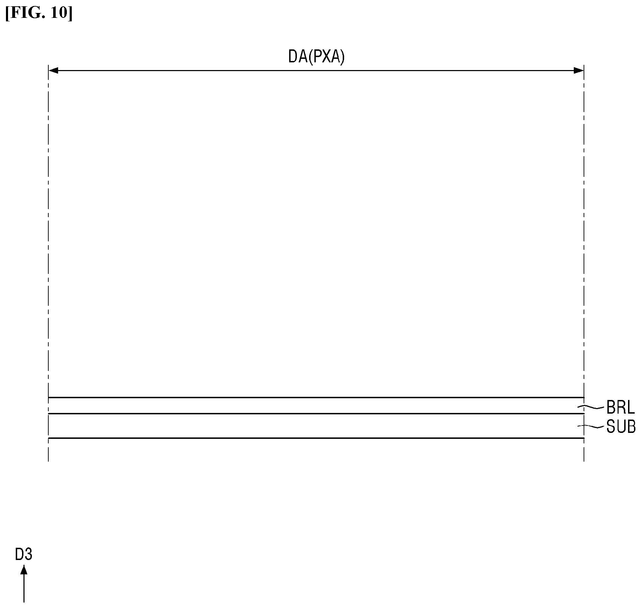

FIGS. 10 to 16 are cross-sectional views illustrating a method for manufacturing the display device 100 according to an embodiment. For example, FIGS. 10 to 16 sequentially illustrate steps of forming the pixel transistors Tpx on the substrate SUB among steps of manufacturing the display panel 110 of FIG. 5 or FIG. 6. In an embodiment, the driver transistors Tdr may be formed simultaneously with the pixel transistors Tpx in a manner that is substantially same as or similar to that of the pixel transistors Tpx.

Referring to FIG. 10 in addition to FIGS. 1 to 7, and FIGS. 8a, 8b, 9a and 9b, the substrate SUB including at least the display area DA may be prepared. The display area DA may include the pixel area PXA.

In an embodiment, the barrier layer BRL may be formed on the substrate SUB. The barrier layer BRL may be formed through a forming process (e.g., a depositing process) of an insulating film using at least one insulating material (e.g., an inorganic insulating material) exemplified above. A material and/or a method for forming the barrier layer BRL may be changed according to embodiments.

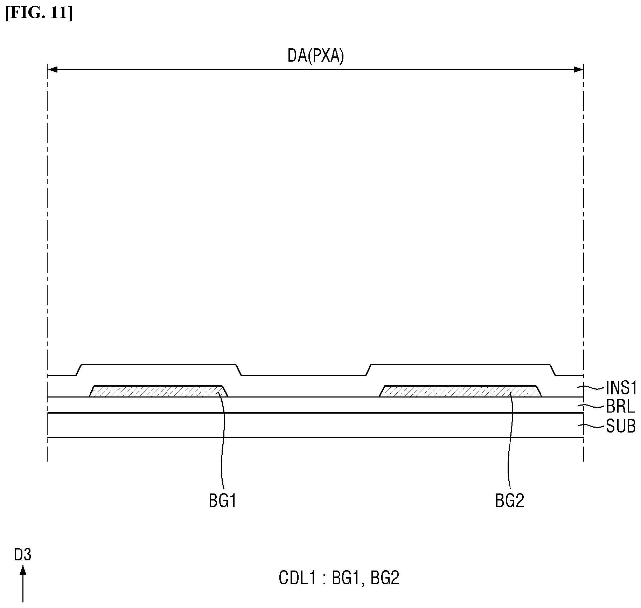

Referring to FIG. 11 in addition to FIGS. 1 to 10, the first conductive layer CDL1 including at least one bottom gate electrode may be formed on the substrate SUB. For example, the first bottom gate electrode BG1 and the second bottom gate electrode BG2 may be formed on the barrier layer BRL on the substrate SUB. The first bottom gate electrode BG1 and the second bottom gate electrode BG2 may be formed in each pixel area PXA.

The first bottom gate electrode BG1 and the second bottom gate electrode BG2 may be formed through a forming process (e.g., a depositing process) of a conductive film using at least one conductive material exemplified above and a patterning process (e.g., an etching process using a mask) of the conductive film. A material and/or a method for forming the first bottom gate electrode BG1 and the second bottom gate electrode BG2 may be changed according to embodiments.

In an embodiment, when the display panel 110 further includes the driver transistor Tdr illustrated in FIG. 7 (e.g., the driver transistor Tdr including the third bottom gate electrode BG3), the first and second bottom gate electrodes BG1 and BG2 are formed in the pixel area PXA, and at the same time, the third bottom gate electrode BG3 may be formed in the driving circuit area DRA. For example, the third bottom gate electrode BG3 may be formed in the driving circuit area DRA using the same conductive material as the first and second bottom gate electrodes BG1 and BG2.

Thereafter, the first insulating layer INS1 covering the first conductive layer CDL1 may be formed on the substrate SUB. The first insulating layer INS1 may be formed through a forming process of an insulating film using at least one insulating material (e.g., an inorganic insulating material) exemplified above. A material and/or a method for forming the first insulating layer INS1 may be changed according to embodiments.

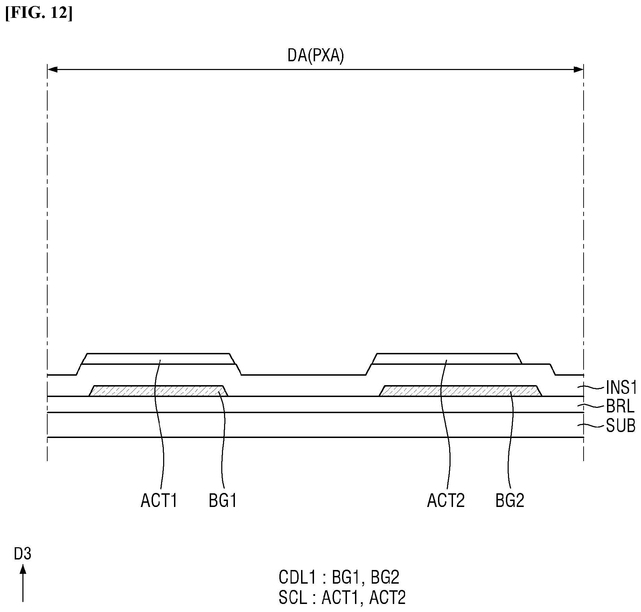

Referring to FIG. 12 in addition to FIGS. 1 to 11, the semiconductor layer SCL including the first active layer ACT1 and the second active layer ACT2 may be formed on the first insulating layer INS1. For example, the first active layer ACT1 and the second active layer ACT2 may be formed in each pixel area PXA. The first active layer ACT1 may be formed to overlap at least a portion of the first bottom gate electrode BG1, and the second active layer ACT2 may be formed to overlap at least a portion of the second bottom gate electrode BG2.

In an embodiment, the active layers ACT provided at the semiconductor layer SCL may be formed simultaneously using the same oxide semiconductor. As an example, the first active layer ACT1 and the second active layer ACT2 may be formed simultaneously using the same oxide semiconductor. For example, the first active layer ACT1 and the second active layer ACT2 may be formed in the pixel area PXA through a forming process and a patterning process of the oxide semiconductor layer using at least one oxide semiconductor exemplified above.

In an embodiment, when the display panel 110 further includes the driver transistor Tdr illustrated in FIG. 7, the first and second active layers ACT1 and ACT2 are formed in the pixel area PXA and at the same time, the third active layer ACT3 may be formed in the driving circuit area DRA. For example, the third active layer ACT3 may be formed on the first insulating layer INS1 in the driving circuit area DRA using the same oxide semiconductor as the first and second active layers ACT1 and ACT2.

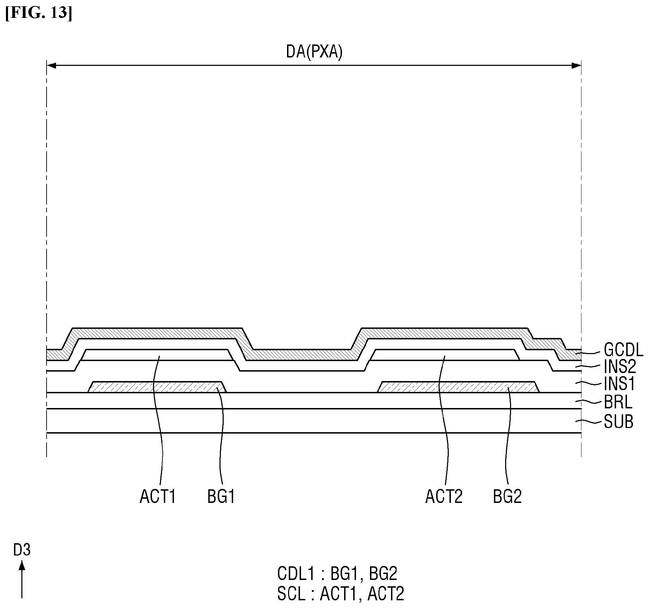

Referring to FIG. 13 in addition to FIGS. 1 to 12, the second insulating layer INS2 covering the semiconductor layer SCL may be formed on the substrate SUB. For example, the second insulating layer INS2 covering the active layers (e.g., the first active layer ACT1, the second active layer ACT2, and/or the third active layer ACT3) provided at the semiconductor layer SCL may be formed on the substrate SUB.

The second insulating layer INS2 may first be entirely formed on the substrate SUB on which the first and second active layers ACT1 and ACT2 and the like are provided. For example, the second insulating layer INS2 may be formed on the substrate SUB on which the semiconductor layer SCL is formed, through a forming process of an insulating film using at least one insulating material (e.g., an inorganic insulating material) as exemplified above, and a subsequent process such as heat treatment (e.g., annealing) may be then performed. A material and/or a method for forming the second insulating layer INS2 may be changed according to embodiments.

Thereafter, a conductive film GCDL may be formed on the second insulating layer INS2. The conductive film GCDL may be used to form the second conductive layer CDL2 including the top gate electrodes of the transistors, and may be formed through a forming process (e.g., a depositing process) of a conductive film using at least one conductive material exemplified above.

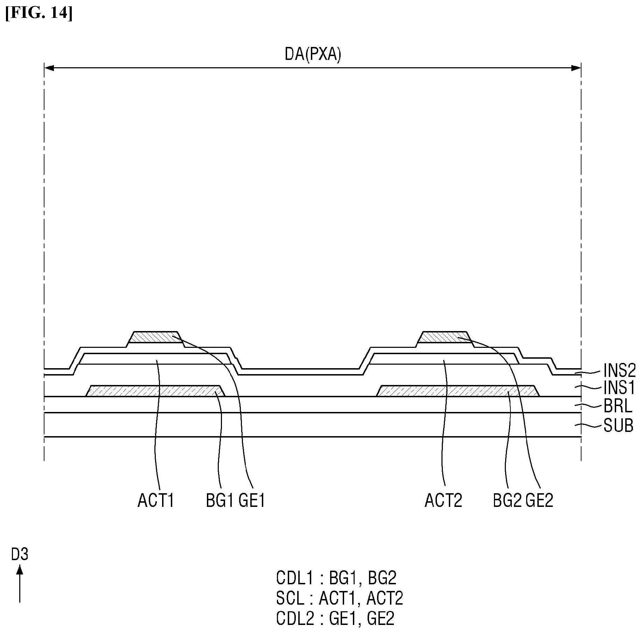

Referring to FIG. 14 in addition to FIGS. 1 to 13, the second conductive layer CDL2 including the first top gate electrode GE1, the second top gate electrode GE2, and the like, may be formed on the second insulating layer INS2 by patterning the conductive film GCDL. For example, top gate electrodes overlapping portions of the respective active layers may be formed by patterning the conductive film GCDL through an etching process using a mask. As an example, in each pixel area PXA, the first top gate electrode GE1 may be formed on the first active layer ACT1 so as to overlap a portion of the first active layer ACT1, and the second top gate electrode GE2 may be formed on the second active layer ACT2 so as to overlap a portion of the second active layer ACT2.

In an embodiment, when the display panel 110 further includes the driver transistor Tdr illustrated in FIG. 7, the first and second top gate electrodes GE1 and GE2 are formed in the pixel area PXA and at the same time, the third top gate electrode GE3 may be formed in the driving circuit area DRA. For example, the first top gate electrode GE1, the second top gate electrode GE2, and the third top gate electrode GE3 may be formed by patterning the conductive film GCDL.

In embodiments, portions of the second insulating layer INS2 that do not overlap the top gate electrodes may be etched by a partial thickness using the same mask as the mask used to etch the conductive film GCDL or using the top gate electrodes as a mask. For example, overetching may be performed in the etching process of the conductive film GCDL using the mask. Alternatively, the second insulating layer INS2 may be etched by a partial thickness at portions that do not overlap the top gate electrodes by etching and patterning the conductive film GCDL into the top gate electrodes and then performing an additional etching process using the mask used to etch the conductive film GCDL or using the top gate electrodes formed by etching the conductive film GCDL as a mask. Accordingly, the second insulating layer INS2 may be formed to have a relatively great thickness (e.g., a first thickness TH1) at the first portion positioned on the channel regions of the transistors and have a relatively small thickness (e.g., a second thickness TH2) at the second portion or the like positioned on the drain regions and the source regions of the transistors. In addition, the first portion of the second insulating layer INS2 may have a pattern shape and/or size (e.g., an area) corresponding to the top gate electrodes of the respective transistors.

In embodiments, the amounts of hydrogen introduced (or permeated) into the drain regions and the source regions of the transistors in a process of manufacturing the display panel 110 may be reduced by etching the second insulating layer INS2 by the partial thickness in a state in which the drain regions and the source regions of the transistors are covered with the second insulating layer INS2. Accordingly, even though the active layers of the transistors are made of a high-mobility oxide semiconductor, conductivity of the active layers, a length of the channel regions, and the like, may be appropriately and/or easily controlled.

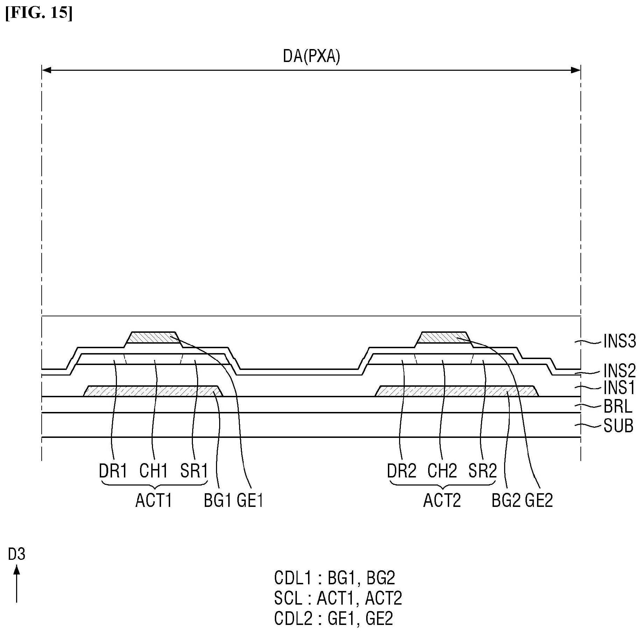

Referring to FIG. 15 in addition to FIGS. 1 to 14, the third insulating layer INS3 may be formed on the top gate electrodes (e.g., the first top gate electrode GE1 and the second top gate electrode GE2) provided at the second conductive layer CDL2 and the second insulating layer INS2. The third insulating layer INS3 may be formed through a forming process of an insulating film using at least one insulating material (e.g., an inorganic insulating material) exemplified above. In an embodiment, a subsequent process such as heat treatment may be performed after the third insulating layer INS3 is formed. A material and/or a method for forming the third insulating layer INS3 may be changed according to embodiments.

In a process of forming the third insulating layer INS3, hydrogen may be introduced or permeated into the active layers of the semiconductor layer SCL including the first active layer ACT1 and the second active layer ACT2. For example, hydrogen may be introduced or permeated into the drain regions and the source regions of the active layers that are not covered by the top gate electrodes.

As hydrogen is introduced or permeated into the first active layer ACT1 and the second active layer ACT2, the first active layer ACT1 and the second active layer ACT2 may be made to be partially conductive (e.g., conductive to N-type). For example, the first drain region DR1, the first source region SR1, the second drain region DR2, and the second source region SR2 may be made to be conductive. In an embodiment, when the display panel 110 further includes the driver transistor Tdr illustrated in FIG. 7, the third drain region DR3 and the third source region SR3 may also be made to be conductive.

In embodiments, the third insulating layer INS3 may be formed in a state in which the active layers are entirely covered by the second insulating layer INS2. Accordingly, amounts of hydrogen introduced (or permeated) from upper portions of the active layers into the active layers may be reduced. For example, compared to a case where the third insulating layer INS3 is formed in a state in which the drain region and the source region of each of the active layers are exposed, amounts of hydrogen introduced (or permeated) from an upper portion of each of the active layers into the drain region and the source region may be reduced. Accordingly, an amount of hydrogen diffused into the channel region is reduced, such that a channel length (or an effective channel length) required to ensure appropriate characteristics of the transistor may be sufficiently ensured at an upper layer portion of the channel region. Hydrogen may also be introduced or permeated from the first insulating layer INS1 or the like into a lower portion of each of the active layers. However, in the case that the amount of hydrogen introduced (or permeated) from the upper portion of each of the active layers is reduced, a total amount of hydrogen introduced (or permeated) into each of the active layers may be reduced. Accordingly, the amount of hydrogen diffused into the channel region is reduced, such that a total channel length (or a total effective channel length) of each of the active layers may increase. As an example, as a top channel length (or an effective channel length of a top channel) of each of the active layers increases, the total channel length (or the total effective channel length) of each of the active layers may increase.

In addition, in embodiments, a thickness of the second insulating layer INS2 may be reduced at the second portion of the second insulating layer INS2 compared to the first portion of the second insulating layer INS2 through partial etching of the second insulating layer INS2. Accordingly, the drain region and the source region of each of the active layers may be appropriately made to be conductive without performing an additional doping process.

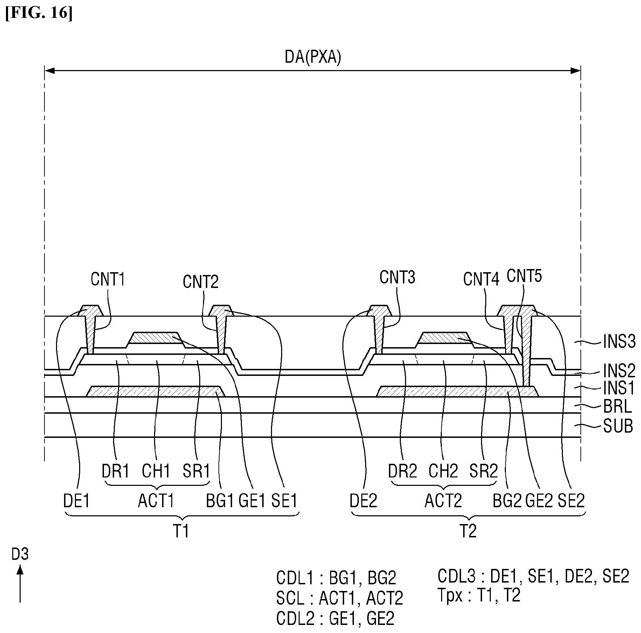

Referring to FIG. 16 in addition to FIGS. 1 to 15, the first drain electrode DE1, the first source electrode SE1, the second drain electrode DE2, and the second source electrode SE2 may be formed on the third insulating layer INS3. In an embodiment, when at least one of the first drain region DR1, the first source region SR1, the second drain region DR2, and the second source region SR2 replaces at least one of the first drain electrode DE1, the first source electrode SE1, the second drain electrode DE2, and the second source electrode SE2, at least one of the first drain electrode DE1, the first source electrode SE1, and the second drain electrode DE2, and the second source electrode SE2 may not be formed.

The first drain electrode DE1 and the first source electrode SE1 may be formed to be connected to different portions of the first active layer ACT1. For example, the first drain electrode DE1 may be formed to be connected to the first drain region DR1, and the first source electrode SE1 may be formed to be connected to the first source region SR1. The second drain electrode DE2 and the second source electrode SE2 may be formed to be connected to different portions of the second active layer ACT2. For example, the second drain electrode DE2 may be formed to be connected to the second drain region DR2, and the second source electrode SE2 may be formed to be connected to the second source region SR2. To this end, before the first drain electrode DE1, the first source electrode SE1, the second drain electrode DE2, and the second source electrode SE2 are formed, a plurality of contact holes (e.g., the first, second, third, fourth, and fifth contact holes CNT1, CNT2, CNT3, CNT4, and CNT5) may be formed in the third insulating layer INS3.

In an embodiment, when the display panel 110 further includes the driver transistor Tdr illustrated in FIG. 7, the first and second drain electrodes DE1 and DE2 and the first and second source electrodes SE1 and SE2 are formed in the pixel area PXA and at the same time, the third drain electrode DE3 and the third source electrode SE3 may be formed in the driving circuit area DRA. For example, a conductive film formed on the third insulating layer INS3 may be etched and patterned into the first, second, and third drain electrodes DE1, DE2, and DE3 and the first, second, and third source electrodes SE1, SE2, and SE3.

Through the above-described processes, a plurality of pixel transistors Tpx including the first transistor T1 and the second transistor T2 may be formed in the display area DA. In an embodiment in which the display panel 110 includes the driving circuit area DRA, a plurality of driver transistors Tdr may be formed in the driving circuit area DRA. In an embodiment, elements provided at the same conductive layer or the same semiconductor layer SCL of the display panel 110 may be formed simultaneously.

After the pixel transistors Tpx and/or the driver transistors Tdr are formed, a process of forming the first passivation layer PSV1 of FIGS. 5 to 7 may be performed. The first passivation layer PSV1 may cover the pixel transistors Tpx and/or the driver transistors Tdr. In an embodiment, a process of forming the fourth conductive layer CDL4 including the connection electrode CNE of each pixel PX on the first passivation layer PSV1 and a process of forming the second passivation layer PSV2 covering the fourth conductive layer CDL4 may be additionally performed. Accordingly, the panel circuit layer PCL of the display panel 110 may be formed.

In an embodiment, when the display panel 110 includes the light emitting element layer LEL and the encapsulation layer ENL disposed on the panel circuit layer PCL, the light emitting element layer LEL and the encapsulation layer ENL may be sequentially formed on the panel circuit layer PCL. Through the above-described processes, the display panel 110 according to embodiments and the display device 100 including the same may be manufactured.

With the display device 100 and the method for manufacturing the same according to embodiments, the second insulating layer INS2 (e.g., the gate insulating layer) interposed between the active layer and the top gate electrode of each of the transistors (e.g., the pixel transistors Tpx and/or the driver transistors Tdr) including the oxide semiconductor may be etched in a half-etching manner. Accordingly, the drain regions and the source regions of the transistors may be appropriately and/or easily made to be conductive in a step of forming the third insulating layer INS3 without performing a separate doping process, and the threshold voltage roll-off (Vth roll-off) of the transistors may be prevented or improved. According to embodiments, operation characteristics of the transistors including the oxide semiconductor may be appropriately ensured.

In addition, according to embodiments, even in a high-resolution display device 100 in which a size of transistors is reduced, an effective channel length may be appropriately and/or easily expanded or ensured. For example, by half-etching the second insulating layer INS2 so that the second insulating layer INS2 covers the drain regions and the source regions of the transistors, the amounts of hydrogen introduced (or permeated) into the drain regions and the source regions may be reduced and/or controlled. Accordingly, by increasing the length of the top channel of each of the transistors, the total channel length and the total effective channel length of each of the transistors may be increased enough to prevent the threshold voltage roll-off (Vth roll-off). Accordingly, according to embodiments, even in the high-resolution display device 100 including transistors having a smaller size, operation characteristics of the transistors may be appropriately and/or easily improved.

In addition, according to embodiments, the second insulating layer INS2 may be etched using the same mask as the mask used to form the top gate electrodes of the transistors or using the top gate electrodes as the mask. Accordingly, a manufacturing process of the display device 100 may be simplified, and a yield of the display device 100 may be improved.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a substrate;
a first transistor including a first bottom gate electrode disposed on the substrate, a first active layer disposed on the first bottom gate electrode and including a first channel region, a first drain region, and a first source region, and a first top gate electrode disposed on a portion of the first active layer including the first channel region;
a first insulating layer disposed between the first bottom gate electrode and the first active layer; and
a second insulating layer disposed between the first active layer and the first top gate electrode,
wherein the second insulating layer includes:
a first portion disposed on a portion of the first active layer including the first channel region, the first portion having a first thickness, and
a second portion disposed on a remaining portion of the first active layer, the second portion having a second thickness smaller than the first thickness.

2. The display device of claim 1, wherein the first channel region includes:
a lower layer portion adjacent to the first bottom gate electrode, the lower layer portion having a first length, and
an upper layer portion adjacent to the first top gate electrode, the upper layer portion having a second length greater than the first length.

3. The display device of claim 2, wherein, in a cross-section of the first active layer, the first channel region has an inverted trapezoidal shape of which a length increases from the lower layer portion toward the upper layer portion.

4. The display device of claim 1, wherein the first channel region includes:
a lower layer portion adjacent to the first bottom gate electrode, and
an upper layer portion adjacent to the first top gate electrode, and
the lower layer portion of the first channel region has a higher carrier concentration than the upper layer portion of the first channel region.

5. The display device of claim 1, wherein
the second insulating layer includes an upper layer portion in contact with the first top gate electrode, and
the upper layer portion of the second insulating layer and the first top gate electrode have a same pattern shape.

6. The display device of claim 1, wherein
the second insulating layer includes an upper layer portion in contact with the first top gate electrode, and
the upper layer portion of the second insulating layer and the first top gate electrode may have a same area.

7. The display device of claim 1, wherein a side surface of the first top gate electrode and a side surface of the second insulating layer have an inclined surface having a continuously connected form.

8. The display device of claim 1, wherein the second insulating layer has a step having a stair shape at a boundary between the first portion and the second portion.

9. The display device of claim 1, further comprising a third insulating layer covering the second insulating layer and the first top gate electrode.

10. The display device of claim 9, further comprising at least one of:
a first drain electrode disposed on the third insulating layer and connected to the first drain region through a first contact hole penetrating through the second insulating layer and the third insulating layer; and
a first source electrode disposed on the third insulating layer and connected to the first source region through a second contact hole penetrating through the second insulating layer and the third insulating layer,
wherein the second insulating layer entirely covers the first active layer except for a portion where at least one of the first contact hole and the second contact hole is formed.

11. The display device of claim 1, wherein the first bottom gate electrode is electrically connected to the first top gate electrode.

12. The display device of claim 1, further comprising a pixel including the first transistor.

13. The display device of claim 12, wherein the pixel further includes a second transistor, and
the second transistor includes:
a second bottom gate electrode disposed on the substrate;
a second active layer disposed on the first insulating layer and including a second channel region, a second drain region, and a second source region; and
a second top gate electrode disposed on the second insulating layer and disposed on a portion of the second active layer including the second channel region.

14. The display device of claim 13, wherein the second insulating layer covers the second active layer, and has the first thickness and the second thickness at a portion of the second active layer including the second channel region and a remaining portion of the second active layer, respectively.

15. The display device of claim 13, wherein the first active layer and the second active layer include the same oxide semiconductor.

16. The display device of claim 12, further comprising a driver connected to the pixel and a driver transistor included in the driver,
wherein the driver transistor includes:
a third bottom gate electrode disposed on the substrate;
a third active layer disposed on the first insulating layer and including a third channel region, a third drain region, and a third source region; and
a third top gate electrode disposed on the second insulating layer and disposed on a portion of the third active layer including the third channel region.

17. The display device of claim 16, wherein the second insulating layer covers the third active layer, and has the first thickness and the second thickness at a portion of the third active layer including the third channel region and a remaining portion of the third active layer, respectively.

18. The display device of claim 16, wherein the first active layer and the third active layer include the same oxide semiconductor.

19. A method for manufacturing a display device, comprising:
forming a first insulating layer on a substrate;
forming an active layer on the first insulating layer;
forming a second insulating layer on the substrate, the second insulating layer covering the active layer;
forming a conductive film on the second insulating layer;
forming a top gate electrode overlapping a portion of the active layer by etching the conductive film; and
forming a third insulating layer on the second insulating layer and the top gate electrode,
wherein the method for manufacturing a display device further comprises, before the forming of the third insulating layer, etching a portion of the second insulating layer that does not overlap the top gate electrode by a partial thickness using the same mask as a mask used to etch the conductive film or using the top gate electrode as a mask.

20. The method for manufacturing a display device of claim 19, further comprising, before the forming of the first insulating layer, forming a bottom gate electrode on the substrate,
wherein the active layer is formed on the first insulating layer so as to overlap at least a portion of the bottom gate electrode.
